(19) 

**Europäisches Patentamt**
**European Patent Office**
**Office européen des brevets**

(11) **EP 4 769 950 A1**

(12) **EUROPEAN PATENT APPLICATION**
published in accordance with Art. 153(4) EPC

(43) Date of publication:
01.07.2026  Bulletin 2026/27

(21) Application number: 24867404.6

(22) Date of filing: 14.09.2024

(51) International Patent Classification (IPC):
*H03K 19/20* $^{(2006.01)}$

(52) Cooperative Patent Classification (CPC):
G06F 7/49; H03K 19/08; H03K 19/20; Y02D 10/00

(86) International application number:
PCT/CN2024/119205

(87) International publication number:
WO 2025/060996 (27.03.2025 Gazette 2025/13)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 18.09.2023  CN 202311209872

(71) Applicant: Huawei Technologies Co., Ltd.
Shenzhen, Guangdong 518129 (CN)

(72) Inventors:
• HU, Hailin
Shenzhen, Guangdong 518055 (CN)

• HUANG, Mingqiang
Shenzhen, Guangdong 518055 (CN)
• ZHAO, Guangchao
Shenzhen, Guangdong 518055 (CN)
• LI, Wenshuo
Shenzhen, Guangdong 518055 (CN)
• WANG, Yunhe
Shenzhen, Guangdong 518055 (CN)

(74) Representative: Gill Jennings & Every LLP
The Broadgate Tower
20 Primrose Street
London EC2A 2ES (GB)

(54) **TERNARY LOGIC GATE CIRCUIT, CALCULATION CIRCUIT, CHIP, AND ELECTRONIC DEVICE**

(57)    This application provides a ternary logic gate circuit, a computing circuit, a chip, and an electronic device. The ternary logic gate circuit provided in this application can add 1 to and subtract 1 from an input logical value. On the basis of the ternary logic gate circuit, the ternary logic gate circuit is applied to a ternary logic circuit by using 27 single-variable functions of three-valued logic, so that a structure of the ternary logic circuit can be simplified, a quantity of transistors in the ternary logic circuit can be reduced, power consumption of the ternary logic circuit can be reduced, and computing efficiency of the ternary logic circuit can be improved.

FIG. 2A

EP 4 769 950 A1

## Description

This application claims priority to Chinese Patent Application No. 202311209872.4, filed with the China National Intellectual Property Administration on September 18, 2023 and entitled "TERNARY LOGIC GATE CIRCUIT, COMPUTING CIRCUIT, CHIP, AND ELECTRONIC DEVICE", which is incorporated herein by reference in its entirety.

## TECHNICAL FIELD

Embodiments of this application relate to the field of multi-valued logic computing technologies, and in particular, to a ternary logic gate circuit, a computing circuit, a chip, and an electronic device.

## BACKGROUND

With the advent of the big data era, processing of a large amount of data requires a chip to have higher computing performance. Currently, it has become increasingly difficult to improve the computing performance of the chip by simply reducing a size of a transistor. Therefore, large-scale integrated circuits may be disposed to improve the computing performance of the chip. However, the large-scale integrated circuits bring higher power consumption and interconnection complexity.

Ternary logic uses three-valued logic to improve information density, and computing performance of ternary logic can surpass computing performance of binary logic. Therefore, computing performance of a ternary logic circuit is higher than computing performance of a binary logic circuit. A ternary logic gate circuit is a basic unit of the ternary logic circuit. Therefore, a design of the ternary logic gate circuit is critical.

## SUMMARY

Embodiments of this application provide a ternary logic gate circuit, a computing circuit, a chip, and an electronic device. The ternary logic gate circuit provided in this application can add 1 to or subtract 1 from an input ternary logical value.

According to a first aspect, an embodiment of this application provides a ternary logic gate circuit. The ternary logic gate circuit includes a first voltage module and a logic gate module. The first voltage module is configured to output a first voltage, where the first voltage indicates a first logical value, and the first logical value is any logical value in ternary logical values. The logic gate module is configured to: receive the first voltage, and output a second voltage, where the second voltage indicates a second logical value, and the second logical value is equal to the first logical value plus 1, or the second logical value is equal to the first logical value minus 1.

An embodiment of this application designs the ternary logic gate circuit, and the ternary logic gate circuit can add 1 to or subtract 1 from an input logical value. As a basic unit of a ternary logic circuit, the ternary logic gate circuit may be applied to the ternary logic circuit, to facilitate the design of a ternary logic circuit with high computing performance.

In a possible implementation, the logic gate module includes a preprocessing unit, a first processing unit, and a second processing unit. The preprocessing unit is configured to: receive the first voltage, and output a third voltage to the first processing unit, where the third voltage indicates a third logical value, and the third logical value is 0 or 2.

For example, the preprocessing unit may be a negative ternary inverter NTI or a positive ternary inverter PTI. For example, the ternary logical values include 0, 1, and 2. When the first logical value is 0, the NTI may output the third logical value 2 after processing the first logical value. When the first logical value is 1, the NTI may output the third logical value 0 after processing the first logical value. When the first logical value is 2, the NTI may output the third logical value 0 after processing the first logical value.

For example, the ternary logical values include 0, 1, and 2. When the first logical value is 0, the PTI may output the third logical value 2 after processing the first logical value. When the first logical value is 1, the NTI may output the third logical value 2 after processing the first logical value. When the first logical value is 2, the NTI may output the third logical value 0 after processing the first logical value.

The first processing unit is configured to: receive the first voltage and the third voltage, and output a fourth voltage to the second processing unit, where the fourth voltage indicates a fourth logical value, and the fourth logical value includes 0 or 2. The second processing unit is configured to: receive the fourth voltage, and output the second voltage.

In some embodiments, the preprocessing unit may include at least one transistor, or the preprocessing unit may include a voltage adjustment unit. After the preprocessing unit receives the first voltage, the first voltage may be processed by a transistor in the preprocessing unit, and then the third voltage may be output. Alternatively, after the preprocessing unit 221 receives the first voltage, the voltage adjustment unit may adjust the first voltage to the third voltage, and output the third voltage.

For structures of the first processing unit and the second processing unit, refer to the descriptions of the preprocessing unit.

In some embodiments, the first processing unit includes a first group of transistors and a second group of transistors, the second processing unit includes a third group of transistors, a threshold voltage of a transistor in the first group of transistors is a first threshold voltage, a threshold voltage of a transistor in the second group of transistors is a second threshold voltage, and a threshold voltage of a transistor in the third group of transistors is a third threshold voltage.

The first threshold voltage is less than or equal to a first threshold, the third threshold voltage is greater than the first threshold and less than or equal to a second threshold, the second threshold voltage is greater than the second threshold, and the first threshold is less than the second threshold. The transistor in the first group of transistors may be referred to as a low voltage threshold transistor, the transistor in the second group of transistors may be referred to as a middle voltage threshold transistor, and the transistor in the third group of transistors may be referred to as a high voltage threshold transistor.

The first voltage module is separately connected to the preprocessing module, a part of transistors in the first group of transistors, and the transistor in the second group of transistors. The preprocessing module is connected to remaining transistors in the first group of transistors. The transistor in the third group of transistors is connected to the transistor in the first group of transistors and the transistor in the second group of transistors.

In this embodiment of this application, the first processing unit and the second processing unit are designed by using transistors with different threshold voltages, so that the logic gate circuit can add 1 to or subtract 1 from the first logical value.

The following separately describes a principle of adding 1 to or subtracting 1 from the first logical value by the logic gate circuit.

First, the logic gate circuit can add 1 to the first logical value, that is, the second logical value is equal to the first logical value plus 1. In some embodiments, the ternary logic gate circuit may be referred to as an auto-substraction ternary logic gate circuit.

The first group of transistors includes a first transistor L1, a second transistor L2, and a third transistor L3, the second group of transistors includes a fourth transistor H1 and a fifth transistor H2, and the third group of transistors includes a sixth transistor M1 and a seventh transistor M2.

The preprocessing module is a negative ternary inverter NTI. The first transistor L1, the second transistor L2, the fourth transistor H1, and the sixth transistor M1 are P-type transistors. The third transistor L3, the fifth transistor H2, and the seventh transistor M2 are N-type transistors.

The following describes a specific structure of an auto-addition ternary logic gate circuit.

The first voltage module is separately connected to a gate of the first transistor L1, a gate of the fourth transistor H1, and a gate of the fifth transistor H2, and the NTI is separately connected to a gate of the second transistor L2 and a gate of the third transistor L3.

A source of the first transistor L1 is connected to a second voltage module, a drain of the first transistor L1 is connected to a source of the second transistor L2, a drain of the second transistor L2 is separately connected to a source of the third transistor L3 and a source of the sixth transistor M1, a drain of the third transistor L3 is grounded, a gate of the sixth transistor M1 is grounded, and a drain of the sixth transistor M1 is connected to a drain of the seventh transistor M2.

A source of the fourth transistor H1 is connected to the second voltage module, a drain of the fourth transistor H1 is separately connected to a source of the fifth transistor H2 and a source of the seventh transistor M2, a drain of the fifth transistor H2 is grounded, and a gate of the seventh transistor M2 is connected to the second voltage module.

It should be understood that, when the first voltage module outputs first voltages, because the first voltages are different, turn-on/off states of the first transistor L1, the second transistor L2, the third transistor L3, the fourth transistor H1, the fifth transistor H2, the sixth transistor M1, and the seventh transistor M2 are also different. For details, refer to Table 1 in the following embodiment. When turn-on/off states of transistors in the ternary logic gate circuit are different, the ternary logic gate circuit may output different second voltages in different cases, and the second logical value indicated by the second voltage is equal to the first logical value plus 1.

Second, the ternary logic gate circuit can subtract 1 from the first logical value, that is, the second logical value is equal to the first logical value minus 1. In some embodiments, the ternary logic gate circuit may be referred to as an auto-addition ternary logic gate circuit.

The first group of transistors includes a first transistor L1, a second transistor L2, and a third transistor L3, the second group of transistors includes a fourth transistor H1 and a fifth transistor H2, and the third group of transistors includes a sixth transistor M1 and a seventh transistor M2.

The preprocessing module is a positive ternary inverter PTI. The first transistor L1, the fourth transistor H1, and the sixth transistor M1 are P-type transistors, and the second transistor L2, the third transistor L3, the fifth transistor H2, and the seventh transistor M2 are N-type transistors.

The following describes a specific structure of the auto-addition ternary logic gate circuit.

The first voltage module is separately connected to a gate of the third transistor L3, a gate of the fourth transistor H1, and a gate of the fifth transistor H2, and the PTI is separately connected to a gate of the first transistor L1 and a gate of the second transistor L2.

A source of the first transistor L1 is connected to a second voltage module, a drain of the first transistor L1 is separately connected to a source of the second transistor L2 and a source of the seventh transistor M2, a drain of the second transistor L2 is connected to a source of the third transistor L3, a drain of the third transistor L3 is grounded, a gate of the seventh transistor M2 is connected to the second voltage module, and a drain of the seventh transistor M2 is connected to a drain of the sixth transistor M1.

A source of the fourth transistor H1 is connected to the second voltage module, a drain of the fourth transistor H1 is separately connected to a source of the fifth transistor H2 and a source of the sixth transistor M1, a drain of the fifth transistor H2 is grounded, and a gate of the sixth transistor M1 is grounded.

In a possible implementation, the ternary logic gate circuit may further include the second voltage module described above. The second voltage module is configured to output a fifth voltage, where a sum of the first threshold voltage and the second threshold voltage is less than the fifth voltage.

It should be understood that, when the first voltage module outputs first voltages, because the first voltages are different, turn-on/off states of the first transistor L1, the second transistor L2, the third transistor L3, the fourth transistor H1, the fifth transistor H2, the sixth transistor M1, and the seventh transistor M2 are also different. For details, refer to Table 1 in the following embodiment. When turn-on/off states of transistors in the ternary logic gate circuit are different, the ternary logic gate circuit may output different second voltages in different cases, and the second logical value indicated by the second voltage is equal to the first logical value minus 1.

According to a second aspect, an embodiment of this application provides an adder circuit. The adder circuit includes a first ternary logic gate circuit and a second ternary logic gate circuit.

In the first ternary logic gate circuit, a second logical value is equal to a first logical value plus 1, and in the second ternary logic gate circuit, a second logical value is equal to a first logical value minus 1. For the first ternary logic gate circuit and the second ternary logic gate circuit, refer to the descriptions in the first aspect.

In a possible implementation, the adder circuit further includes a signal processing module, a first pass transistor, a second pass transistor, and a third pass transistor.

The signal processing module is configured to connect to a first signal module, and the signal processing module is separately connected to the first pass transistor, the second pass transistor, and the third pass transistor. A second signal module is configured to be separately connected to the first pass transistor, the first ternary logic gate circuit, and the second ternary logic gate circuit. The first ternary logic gate circuit is connected to the second pass transistor, and the second ternary logic gate circuit is connected to the third pass transistor.

The second signal module is configured to output a second signal. The first signal module is configured to output a first signal. The signal processing module is configured to turn on any pass transistor based on the first signal, to enable the adder circuit to output a first summation result of the first signal and the second signal.

In this implementation, the adder circuit provided in this embodiment of this application may perform summation calculation on two ternary signals, and output the first summation result.

In a possible implementation, the first signal indicates a fifth logical value, and the second signal indicates a sixth logical value; when the first pass transistor is turned on, the first summation result is a sum of the fifth logical value and the sixth logical value; when the second pass transistor is turned on, the first summation result is a sum of the sixth logical value plus 1 and the fifth logical value; and when the third pass transistor is turned on, the first summation result is a sum of the sixth logical value minus 1 and the fifth logical value.

In a possible implementation, the signal processing module includes a first NTI, a second NTI, a PTI, and an NOR gate.

The first signal module is separately connected to a first end of the first NTI and a first end of the PTI, a second end of the first NTI is separately connected to the first pass transistor and a first input end of the NOR gate, a second end of the PTI is connected to a first end of the second NTI, a second end of the second NTI is separately connected to a second input end of the NOR gate and the third pass transistor, and an output end of the NOR gate is connected to the second pass transistor.

According to a third aspect, an embodiment of this application provides a half-adder circuit. The half-adder circuit may include the adder circuit in the second aspect.

In a possible implementation, the half-adder circuit further includes a first carry generator. A first signal module is configured to be separately connected to the adder circuit and the first carry generator, and a second signal module is configured to be separately connected to the adder circuit and the first carry generator. The first carry generator is configured to output a first carry result.

In this implementation, when performing summation calculation on a first signal and a second signal, the half-adder circuit may not only output a first summation result of the first signal and the second signal, but also output the first carry result when performing summation calculation on the first signal and the second signal, so that a summation calculation result of the first signal and the second signal can be accurately output.

According to a fourth aspect, an embodiment of this application provides a full-adder circuit, including the half-adder circuit in the third aspect. The half-adder circuit may be referred to as a first-stage half-adder circuit.

In a possible implementation, the full-adder circuit further includes a second-stage half-adder circuit and a second carry generator, and the second-stage half-adder circuit is configured to connect to a third signal module.

The first-stage half-adder circuit is configured to: output a first summation result to the second-stage half-adder circuit, and output a first carry result to the second carry generator. The third signal module is configured to output a third signal to the second-stage half-adder circuit.

The second-stage half-adder circuit is configured to: output, based on the third signal and the first summation result, a second summation result, and output a second carry result to the second carry generator. The second carry generator is configured to output a third carry result based on the first carry result and the second carry result.

In this implementation, the full-adder circuit is provided, to accurately implement summation calculation on three ternary signals.

In a possible implementation, the second-stage half-adder circuit includes a third ternary logic gate circuit. In the third ternary logic gate circuit, a second logical value is equal to a first logical value plus 1. In other words, the third ternary logic gate circuit may be an auto-addition ternary logic gate circuit. For the third ternary logic gate circuit, refer to the descriptions in the first aspect.

In a possible implementation, the second-stage half-adder circuit includes a positive buffer PB, a negative buffer NB, a fourth pass transistor, a fifth pass transistor, an AND gate, and the third ternary logic gate circuit.

The third signal module is separately connected to an input end of the PB and the fourth pass transistor, an output end of the PB is separately connected to the fifth pass transistor and a second input end of the AND gate, and the fourth pass transistor is connected to the fifth pass transistor. The first-stage half-adder circuit is separately connected to the third ternary logic gate circuit and an input end of the NB, the third ternary logic gate circuit is connected to the fifth pass transistor, and an output end of the NB is connected to a first input end of the AND gate.

The third signal is used to turn on the fourth pass transistor or the fifth pass transistor, to enable the full-adder circuit to output the second summation result.

An embodiment of this application provides a full-adder circuit. An adder circuit may be designed based on an auto-addition logic gate circuit and an auto-substraction logic gate circuit, a half-adder circuit is designed based on the adder circuit, and the full-adder circuit that can perform summation on three ternary signals is designed based on a first-stage half-adder circuit. In this way, the full-adder circuit has a small quantity of transistors, low power consumption, and high computing efficiency.

According to a fifth aspect, an embodiment of this application provides a multiplication circuit. The multiplication circuit may include the adder circuit in the second aspect and the half-adder circuit in the third aspect.

In a possible implementation, the multiplication circuit further includes a multiplier and an approximate multiplier. The multiplier is configured to output a first multiplication result. The approximate multiplier is configured to output a second multiplication result. The adder circuit and the half-adder circuit are configured to output a third multiplication result based on the first multiplication result and the second multiplication result.

In this implementation, the approximate multiplier is disposed in the multiplication circuit by using an idea of approximate multiplication calculation. Approximate multiplication calculation may achieve higher calculation performance and lower power consumption by tolerating a small calculation error.

Herein, an example in which the multiplication circuit is a 2trit*2trit multiplication circuit is used. The approximate multiplier includes a first approximate multiplier, a second approximate multiplier, and a third approximate multiplier. The half-adder circuit includes a first half-adder circuit and a second half-adder circuit.

The first approximate multiplier is configured to output a first multiplication sub-result.

The second approximate multiplier is configured to output a second multiplication sub-result to the first half-adder circuit. The third approximate multiplier is configured to output a third multiplication sub-result to the first half-adder circuit. The first half-adder circuit is configured to: output a fourth multiplication sub-result based on the second multiplication sub-result and the third multiplication sub-result, and output a fifth multiplication sub-result to the second half-adder circuit.

The multiplier is further configured to output the first multiplication result to the second half-adder circuit. The second half-adder circuit is configured to: output a sixth multiplication sub-result based on the fifth multiplication sub-result and the first multiplication result, and output a seventh multiplication sub-result to the adder circuit.

The adder circuit is configured to output an eighth multiplication sub-result based on the first multiplication result and the seventh multiplication sub-result.

In conclusion, the third multiplication result includes the first multiplication sub-result, the fourth multiplication sub-result, the sixth multiplication sub-result, and the eighth multiplication sub-result.

It should be understood that the adder circuit and the half-adder circuit in this embodiment of this application may be further applicable to a 6trit*6trit ternary multiplication circuit, or may be even applicable to a circuit design of a larger scale and a circuit design of any scale, and all belong to the protection scope of embodiments of this application.

According to a sixth aspect, an embodiment of this application provides a computing circuit. The computing circuit is a ternary logic computing circuit. The ternary logic computing circuit may include at least one of the following: the adder circuit in the second aspect, the half-adder circuit in the third aspect, the full-adder circuit in the fourth aspect, and the multiplication circuit in the fifth aspect.

According to a seventh aspect, an embodiment of this application provides a chip. The chip may include any one of the following circuits: the ternary logic gate circuit in the first aspect, the adder circuit in the second aspect, the half-adder circuit in the third aspect, the full-adder circuit in the fourth aspect, and the multiplication circuit in the fifth aspect.

According to an eighth aspect, an embodiment of this application provides a chip. The chip may include at least one of the following circuits: the adder circuit in the second aspect, the half-adder circuit in the third aspect, the full-adder circuit in the fourth aspect, and the multiplication circuit in the fifth aspect.

According to a ninth aspect, an embodiment of this application provides an electronic device. The electronic device may include the chip in the seventh aspect or the chip in the eighth aspect.

For beneficial effect of the possible implementations of the sixth aspect to the ninth aspect, refer to related descriptions of beneficial effect in the first aspect to the fifth aspect. Details are not described herein again.

Embodiments of this application provide the ternary logic gate circuit, the computing circuit, the chip, and the electronic device. The ternary logic gate circuit may include the first voltage module and the logic gate module. The first voltage module is configured to output the first voltage, where the first voltage indicates the first logical value, and the first logical value is any logical value in the ternary logical values. The logic gate module is configured to: receive the first voltage, and output the second voltage, where the second voltage indicates the second logical value, and the second logical value is equal to the first logical value plus 1, or the second logical value is equal to the first logical value minus 1. The ternary logic gate circuit provided in this application can add 1 to and subtract 1 from the input logical value. In addition, based on the ternary logic gate circuit, the ternary logic gate circuit is applied to a ternary logic circuit by using 27 single-variable functions of three-valued logic, so that a structure of the ternary logic circuit can be simplified, a quantity of transistors in the ternary logic circuit can be reduced, power consumption of the ternary logic circuit can be reduced, and computing efficiency of the ternary logic circuit can be improved.

## BRIEF DESCRIPTION OF DRAWINGS

FIG. 1A is a schematic of a ternary logic circuit;
FIG. 1B is a schematic of a design for another ternary logic circuit;
FIG. 2A is a schematic of a ternary logic gate circuit according to an embodiment of this application;
FIG. 2B is a schematic of a ternary logic gate circuit according to an embodiment of this application;
FIG. 3 is a schematic of an auto-addition logic gate circuit according to an embodiment of this application;
FIG. 4 is a schematic of an auto-substraction logic gate circuit according to an embodiment of this application;
FIG. 5 is a schematic of an adder circuit according to an embodiment of this application;
FIG. 6 is a schematic of a half-adder circuit according to an embodiment of this application;
FIG. 7 is a schematic of a full-adder circuit according to an embodiment of this application;
FIG. 8 is a schematic of a second-stage half-adder circuit in a full-adder circuit according to an embodiment of this application;
FIG. 9 shows schematics of a positive buffer and a negative buffer according to an embodiment of this application;
FIG. 10 is a schematic of a second carry generator according to an embodiment of this application;
FIG. 11 is a schematic of comparison between an existing ternary multiplication circuit and a ternary multiplication circuit according to an embodiment of this application;
FIG. 12 is a diagram of ternary approximation calculation multiplication;
FIG. 13 is a schematic of a ternary multiplication circuit according to an embodiment of this application;
FIG. 14 is another schematic of a ternary multiplication circuit according to an embodiment of this application; and
FIG. 15 is another schematic of comparison between an existing ternary multiplication circuit and a ternary multiplication circuit according to an embodiment of this application.

## DESCRIPTION OF EMBODIMENTS

Technologies such as artificial intelligence, automation, and intelligent driving develop rapidly, and data generated by the technologies is also growing explosively. With the advent of the big data era, processing of a large amount of data requires a chip to have higher computing performance. In one aspect, a size of a transistor can be reduced, more transistors can be integrated on the chip, and computing performance of the chip can be improved. However, when the size of the transistor is reduced to a specific extent, it is difficult to further reduce the size of the transistor. In another aspect, a large-scale integrated circuit may be disposed to improve the computing performance of the chip. However, the large-scale integrated circuit brings higher power consumption and interconnection complexity, and further causes a data processing delay.

Currently, a logic circuit integrated in a chip is a binary logic circuit. Compared with binary logic, multi-valued logic (multi-valued logic, MVL) uses three-valued, four-valued, or even larger-valued logic to improve information density. This helps reduce interconnection complexity of the chip. A circuit design implemented by using multi-valued logic has advantages such as higher information density, a reduced chip area, and an improved computing capability of the integrated circuit. Therefore, currently, a multi-valued logic circuit may be designed based on multi-valued logic, to improve the computing performance of the chip.

In multi-valued logic, a theoretical efficiency value of ternary logic is the highest. Therefore, deploying a ternary logic circuit on the chip can improve the computing performance of the chip. Accordingly, a design of the ternary logic circuit is critical. In some embodiments, the ternary logic circuit may also be referred to as a ternary circuit or a ternary logic computing circuit.

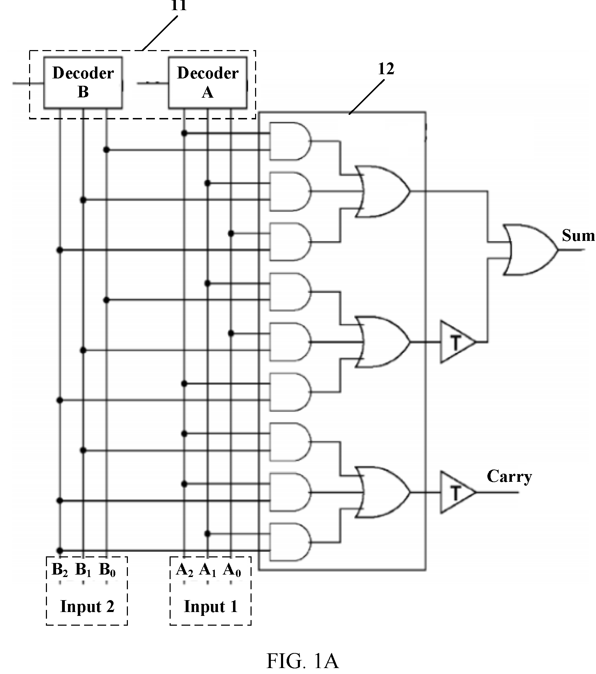

In some embodiments, a decoder 11 and a binary circuit 12 may be deployed on the chip. For example, the chip implements ternary addition calculation. Refer to FIG. 1A. For example, the decoder 11 may include a decoder A and a decoder B, and the chip may receive an input 1 and an input 2, and perform addition calculation on the input 1 and the input 2. The input 1 includes $A_0$, $A_1$, and $A_2$, and the input 2 includes $B_0$, $B_1$, and $B_2$.

After the chip receives the input 1 and the input 2, the decoder A may convert the input 1 into a binary logical value, the decoder B may convert the input 2 into a binary logical value, and the binary circuit 12 may perform addition calculation on the binary logical value obtained by the decoder A through conversion and the binary logical value obtained by the decoder B through conversion, and output a result.

Although the solution in FIG. 1A can implement ternary logic addition calculation, the circuit has much higher interconnection complexity than that of a binary logic circuit with a same function, and has low computing efficiency.

In some embodiments, a ternary logic circuit may be directly deployed based on a truth table of ternary logic. The solution may include the following steps:

Step 1: Formulate the truth table of ternary logic.

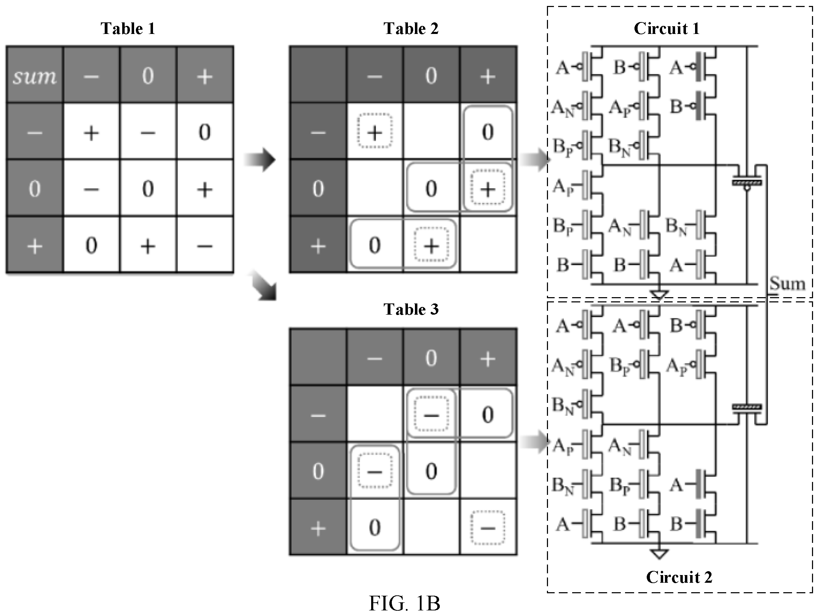

Ternary addition calculation is used as an example. FIG. 1B shows a truth table of ternary logic addition. It should be understood that, in Table 1, -1, 0, and 1 represent ternary logical values, "-" in Table 1 may represent -1, and "+" may represent +1.

After the ternary logical values are summed in pairs, Table 2 in FIG. 1B may be understood as a pull-up switching map (pull up switching map), and shows some of addition results with an increase in a logical value; and Table 3 in FIG. 1B may be understood as a pull-down switching map (pull down switching map), and shows some of addition results with a decrease in a logical value.

Step 2: Optimize an expression and determine a minimum quantity of transistors and a minimum delay in the ternary logic circuit.

Step 3: Select a best sum of products (sum of products, SOP).

Step 4: Perform transistor mapping to obtain the ternary logic circuit.

A circuit whose logical value increases and that is obtained through transistor mapping in Table 2 may be shown in a circuit 1 in FIG. 1B. A circuit whose logical value decreases and that is obtained through transistor mapping in Table 3 may be shown in a circuit 2 in FIG. 1B. It should be understood that, for example, addition calculation is performed on a ternary signal A and a ternary signal B. In the circuit 1 and the circuit 2, A represents the ternary signal A, B represents the ternary signal B, $A_N$ represents that the ternary signal A is output after being processed by a negative ternary inverter (negative ternary inverter, NTI), $A_P$ represents that the ternary signal A is output after being processed by a positive ternary inverter (positive ternary inverter, PTI), $B_N$ represents that the ternary signal B is output after being processed by the NTI, and $B_P$ represents that the ternary signal B is output after being processed by the PTI.

Although this solution can implement the ternary logic addition circuit, designing a ternary logic circuit based on a truth table of ternary logic has disadvantages of a complex structure, a large quantity of transistors, a large circuit delay, high power consumption, and low computing performance. For specific details of the solution, refer to content in the conventional technology "A logic synthesis methodology for low-power ternary logic circuits".

In conclusion, it is critical to design a ternary logic circuit with a simple structure and a small quantity of transistors. A ternary logic gate circuit is used as a basic unit of the ternary logic circuit. Therefore, a design of the ternary logic gate circuit is critical. Currently, all ternary logic gate circuits (as shown in FIG. 1B) are directly designed based on addition calculation, multiplication calculation, and the like performed on input signals, and there is no design solution for the ternary logic gate circuit. It should be understood that, when the ternary logic circuit has a simple structure and a small quantity of transistors, the ternary logic circuit has a small circuit delay, low power consumption, and high computing performance.

It should be understood that, in a circuit design, a single-variable function f(x) is a means for implementing a digital function, and is widely applied. In three-valued logic, a variable x of the single-variable function f(x) has three values: 0, 1, and 2, that is, x∈{0,1,2}. It should be noted that, in the following embodiments, an example in which logical values in three-valued logic include "0, 1, and 2" is used.

Corresponding to different values of x, output values of the single-variable function f(x) are different. When x=0, an output value of f(x) is C0, and C0=f(0); when x=1, an output value of f(x) is C1, and Cl=f(1); and when x=2, an output value of f(x) is C2, and C2=f(2). C0∈{0,1,2}, C1∈{0,1,2}, and C2∈{0,1,2}. According to a design principle of a multi-valued logic circuit, there are $3^3$=27 types of three-valued logic single-variable functions, and output values C0, C1, and C2 of these single-variable functions when x=0, x=1, and x=2 are sorted in ascending order of values of three-digit numbers C0, C1, and C2 in a ternary numeral system, and are respectively f0, f1, f2, f3, f4, f5, f6, f7, f8, f9, f10, f11, f12, f13, f14, f15, f16, f17, f18, f19, f20, f21, f22, f23, f24, f25, and f26.

f0={0,0,0}, fl={0,0,1}, f2={0,0,2}, f3={0,1,0}, f4={0,1,1}, f5={0,1,2}, f6={0,2,0}, f7={0,2,1}, f8={0,2,2}, f9={1,0,0}, f10={1,0,1}, f11={1,0,2}, f12={1,1,0}, f13={1,1,1}, f14={1,1,2}, fl5={1,2,0}, fl6={1,2,1}, f17={1,2,2}, fl8={2,0,0}, fl9={2,0,1}, f20={2,0,2}, f21={2,1,0}, f22={2,1,1}, f23={2,1,2}, f24={2,2,0}, f25={2,2,1}, and f26={2,2,2}.

Based on the single-variable function of three-valued logic, any input and output may be represented by using the single-variable function of three-valued logic. Therefore, in embodiments of this application, a ternary logic gate circuit is designed, and the ternary logic gate circuit is configured to add 1 to and subtract 1 from an input logical value. Based on the ternary logic gate circuit, in embodiments of this application, the ternary logic gate circuit is widely applied to a ternary logic circuit by using the 27 single-variable functions of three-valued logic, so that a structure of the ternary logic circuit can be simplified, a quantity of transistors in the ternary logic circuit can be reduced, power consumption of the ternary logic circuit can be reduced, and computing efficiency of the ternary logic circuit can be improved.

The following describes the ternary logic gate circuit, the ternary logic computing circuit (computing circuit), a chip, and an electronic device provided in embodiments of this application with reference to specific embodiments. The following several embodiments may be combined with each other, and a same or similar concept or process may not be described again in some embodiments.

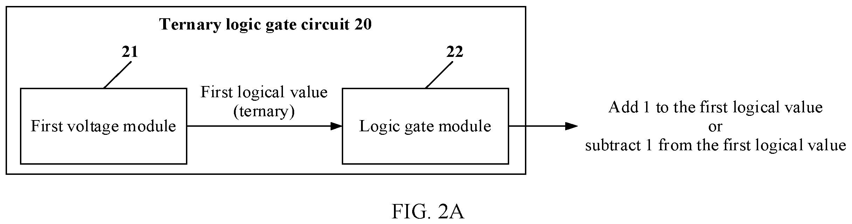

An embodiment of this application provides a ternary logic gate circuit. Refer to FIG. 2A. A ternary logic gate circuit 20 includes a first voltage module 21 and a logic gate module 22.

The first voltage module 21 is configured to output a first voltage. Specifically, the first voltage module 21 is configured to output the first voltage to the logic gate module 22. The first voltage indicates a first logical value, and the first logical value is any logical value in ternary logical values. For example, the first logical value is any one of the following: 0, 1, and 2. In some embodiments, the first logical value may be any one of the following: -1, 0, and 1. In this embodiment of this application, an example in which the ternary logical values include "0, 1, and 2" is used for description.

In some embodiments, a mapping relationship between the first voltage and the first logical value may be preset. For example, when the first voltage is a value A, the first voltage indicates a first logical value 0; when the first voltage is a value B, the first voltage indicates a first logical value 1; and when the first voltage is a value C, the first voltage indicates a first logical value 2. For example, when the first voltage is 0 V (the value A), the first voltage indicates the first logical value 0; when the first voltage is 0.5 V (the value B), the first voltage indicates the first logical value 1; and when the first voltage is 1 V, the first voltage indicates the first logical value 2.

In some embodiments, the first voltage may also be considered as a first level. For example, a mapping relationship between the first level and the first logical value may be preset. For example, a low level indicates the first logical value 0, a medium level indicates the first logical value 1, and a high level indicates the first logical value 2. The low level, the medium level, and the high level may be preconfigured.

The logic gate module 22 is configured to: receive the first voltage from the first voltage module 21, and output a second voltage. The second voltage indicates a second logical value, and the second logical value is equal to the first logical value plus 1, or the second logical value is equal to the first logical value minus 1. In other words, in this embodiment of this application, the logic gate module 22 can add 1 to or subtract 1 from the first logical value.

In some embodiments, the logic gate module 22 may include a plurality of transistors. For example, when receiving the first voltage, the logic gate module 22 may control a first transistor in the plurality of transistors to be turned on, to enable the logic gate module 22 to output the second voltage, where the second logical value indicated by the second voltage is equal to the first logical value plus 1. For example, when receiving the first voltage, the logic gate module 22 may control a second transistor in the plurality of transistors to be turned on, to enable the logic gate module 22 to output the second voltage, where the second logical value indicated by the second voltage is equal to the first logical value minus 1. The first transistor may include a part of the plurality of transistors, the second transistor may include a part of the plurality of transistors, and the first transistor is different from the second transistor.

In some embodiments, the logic gate module 22 may include a first voltage adjustment unit and a second voltage adjustment unit. For example, when receiving the first voltage, the logic gate module 22 may turn on the first voltage adjustment unit and turn off the second voltage adjustment unit. The first voltage adjustment unit may adjust the first voltage to the second voltage, and the second logical value indicated by the second voltage is equal to the first logical value plus 1. For example, when receiving the first voltage, the logic gate module 22 may turn on the second voltage adjustment unit and turn off the first voltage adjustment unit. The second voltage adjustment unit is configured to adjust the first voltage to the second voltage, and the second logical value indicated by the second voltage is equal to the first logical value minus 1. In some embodiments, the first voltage adjustment unit may include a capacitor and/or a resistor, and the second voltage adjustment unit may include a capacitor and/or a resistor.

The ternary logic gate circuit provided in this embodiment of this application can add 1 to or subtract 1 from the input first logical value. In other words, the ternary logic gate circuit can implement auto-addition or auto-subtraction of the logical value. Auto-addition may indicate the first logical value plus 1, and auto-subtraction may indicate the first logical value minus 1.

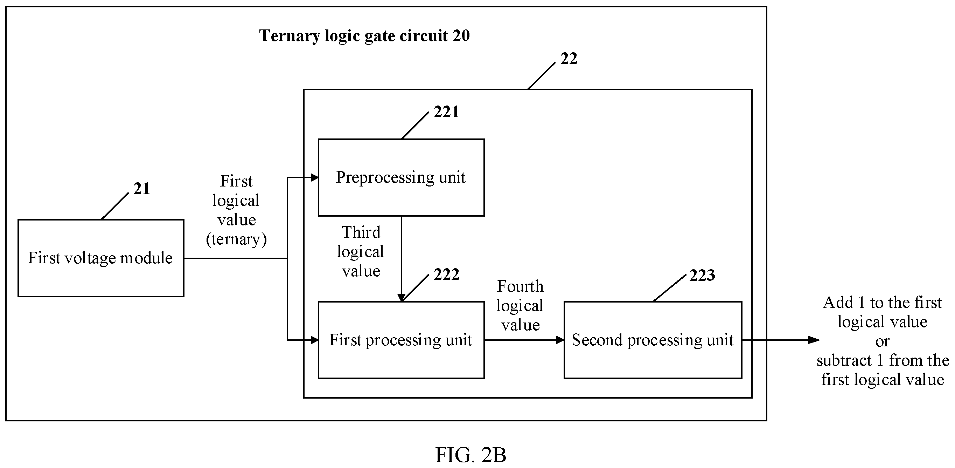

Refer to FIG. 2B. In some embodiments, the logic gate module 22 includes a preprocessing unit 221, a first processing unit 222, and a second processing unit 223.

The first voltage module 21 is configured to output the first voltage to the preprocessing unit 221 and the first processing unit 222. Correspondingly, the preprocessing unit 221 may receive the first voltage from the first voltage module 21, and the first processing unit 222 may receive the first voltage from the first voltage module 21.

After receiving the first voltage, the preprocessing unit 221 may output a third voltage to the first processing unit 222. The third voltage indicates a third logical value, and the third logical value is 0 or 2.

In some embodiments, the preprocessing unit 221 may include at least one transistor, or the preprocessing unit 221 may include a voltage adjustment unit. After the preprocessing unit 221 receives the first voltage, the first voltage may be processed by the transistor in the preprocessing unit 221, and then the third voltage is output. Alternatively, after the preprocessing unit 221 receives the first voltage, the voltage adjustment unit may adjust the first voltage to the third voltage, and output the third voltage.

The first processing unit 222 may receive the first voltage from the first voltage module 21 and the third voltage from the preprocessing unit 221. The first processing unit 222 may output a fourth voltage to the second processing unit 223. The fourth voltage indicates a fourth logical value, and the fourth logical value is 0 or 2.

In some embodiments, the first processing unit 222 may include at least one transistor, or the first processing unit 222 may include a voltage adjustment unit. After the first processing unit 222 receives the first voltage and the third voltage, the first voltage and the third voltage may be processed by the transistor in the first processing unit 222, and then the fourth voltage is output. Alternatively, after the first processing unit 222 receives the first voltage and the third voltage, the voltage adjustment unit may adjust the voltage to the fourth voltage, and output the fourth voltage.

The second processing unit 223 may receive the fourth voltage from the first processing unit 222, and output the second voltage.

In some embodiments, the second processing unit 223 may include at least one transistor, or the second processing unit 223 may include a voltage adjustment unit. After the second processing unit 223 receives the fourth voltage, the fourth voltage may be processed by the transistor in the second processing unit 223, and then the second voltage may be output. Alternatively, after the second processing unit 223 receives the fourth voltage, the voltage adjustment unit may adjust the fourth voltage to the second voltage, and output the second voltage.

In this embodiment of this application, the preprocessing unit 221, the first processing unit 222, and the second processing unit 223 are disposed in the logic gate module 22, to add 1 to or subtract 1 from the first logical value.

In this embodiment of this application, the ternary logic gate circuit is designed based on 27 single-variable functions of three-valued logic. To further resolve problems such as a large quantity of transistors and high power consumption in a ternary logic circuit in the conventional technology, the first processing unit 222 and the second processing unit 223 in this embodiment of this application may also include transistors. In this way, the ternary logic gate circuit in this embodiment of this application can be clearly compared with an exsiting ternary logic gate circuit, and the ternary logic circuit provided in this embodiment of this application has a small quantity of transistors, low power consumption, and high computing performance.

In some embodiments, the first processing unit 222 includes a first group of transistors and a second group of transistors, and the second processing unit 223 includes a third group of transistors. In some embodiments, the first group of transistors may include at least one transistor, the second group of transistors may include at least one transistor, and the third group of transistors may include at least one transistor.

The first voltage module 21 is separately connected to the preprocessing module 221, a part of transistors in the first group of transistors, and a transistor in the second group of transistors. In this way, the first voltage module 21 may separately output the first voltage to the preprocessing module 221, and output the first voltage to the first processing unit 222 (for example, the part of transistors in the first group of transistors and the transistor in the second group of transistors).

The preprocessing module 221 is connected to remaining transistors in the first group of transistors, and the transistor in the third group of transistors is connected to the transistor in the first group of transistors and the transistor in the second group of transistors. In this way, when outputting the third voltage, the preprocessing module 221 may output the third voltage to the first processing unit 222 (for example, the remaining transistors in the first group of transistors), and the first processing unit 222 may output the fourth voltage to the second processing unit 223 (for example, the third group of transistors).

In some embodiments, the first group of transistors, the second group of transistors, and the third group of transistors may use transistors of a same type or different types, for example, insulated gate bipolar transistors (Insulated Gate Bipolar Transistor, IGBT), metal-oxide-semiconductor (Metal Oxide Semiconductor, MOS) field effect transistors, and the like.

In some embodiments, transistors in the first group of transistors, the second group of transistors, and the third group of transistors may be carbon nanotube field effect transistors (carbon nano tube field effect transistor, CNTFET). In this embodiment of this application, in the ternary logic gate circuit, a component with high power consumption such as a resistor is not used, but a CNTFET is used, so that power consumption of the ternary logic gate circuit can be further reduced.

A threshold voltage (threshold voltage, Vth) of the CNTFET is related to a diameter of a CNT, and the diameter of the CNT depends on a chiral vector. Therefore, the threshold voltage of the CNTFET may be controlled by changing the diameter or the chiral vector of the CNT. It should be understood that a threshold voltage of a transistor is a voltage for enabling the transistor to be turned on. When a voltage difference between a gate and a source (or a drain) of the transistor is greater than or equal to the threshold voltage of the transistor, the transistor is turned on. When a voltage difference between the gate and the source (or the drain) of the transistor is less than the threshold voltage of the transistor, the transistor is turned off (or is in a cut-off state).

In some embodiments, threshold voltages of the transistors in the first group of transistors, the second group of transistors, and the third group of transistors may be the same.

In some embodiments, threshold voltages of the transistors in the first group of transistors, the second group of transistors, and the third group of transistors may be different. For example, the threshold voltage of the transistor in the first group of transistors is a first threshold voltage, the threshold voltage of the transistor in the second group of transistors is a second threshold voltage, and the threshold voltage of the transistor in the third group of transistors 2223 is a third threshold voltage. The first threshold voltage is less than or equal to a first threshold, the third threshold voltage is greater than the first threshold and less than or equal to a second threshold, and the first threshold is less than the second threshold. For example, the first threshold may be 0.35 V, and the second threshold may be 0.5 V. The first threshold voltage may be set to 0.2 V to 0.3 V, the third threshold voltage may be set to 0.4 V, and the second threshold voltage may be set to 0.6 V to 0.7 V.

In some embodiments, the transistor in the first group of transistors may be referred to as a low voltage threshold (low V threshold, LVT) transistor, the transistor in the second group of transistors may be referred to as a high voltage threshold (high V threshold, HVT) transistor, and the transistor in the third group of transistors 2221 may be referred to as a middle voltage threshold (middle V threshold) transistor.

Specific values of the first threshold voltage, the second threshold voltage, and the third threshold voltage are not limited in this embodiment of this application. The first threshold voltage, the second threshold voltage, and the third threshold voltage may be related to a voltage output by a second voltage module. For the first threshold voltage, the second threshold voltage, the third threshold voltage, and the second voltage module, refer to descriptions in the following embodiments.

The following describes, with reference to specific examples, a principle that the ternary logic gate circuit can add 1 to or subtract 1 from the first logical value.

Example 1: The ternary logic gate circuit can add 1 to the first logical value, that is, the second logical value is equal to the first logical value plus 1.

In some embodiments, the preprocessing module 221 is a negative ternary inverter (negative ternary inverter, NTI). The first group of transistors includes a first transistor L1, a second transistor L2, and a third transistor L3, the second group of transistors includes a fourth transistor H1 and a fifth transistor H2, and the third group of transistors includes a sixth transistor M1 and a seventh transistor M2.

In some embodiments, the first group of transistors, the second group of transistors, and the third group of transistors may use transistors of a same polarity or different polarities, and the polarities may include an N-type and a P-type. In some embodiments, the first transistor L1, the second transistor L2, the fourth transistor H1, and the sixth transistor M1 are P-type transistors, and the third transistor L3, the fifth transistor H2, and the seventh transistor M2 are N-type transistors.

In some embodiments, the ternary logic gate circuit may further include the second voltage module, and the second voltage module may provide a fifth voltage ($V_{DD}$) for the logic gate module 22.

In some embodiments, the first voltage module 21 and the second voltage module may not be included in the ternary logic gate circuit. The ternary logic gate circuit may receive the first voltage from the first voltage module 21 and the fifth voltage from the second voltage module.

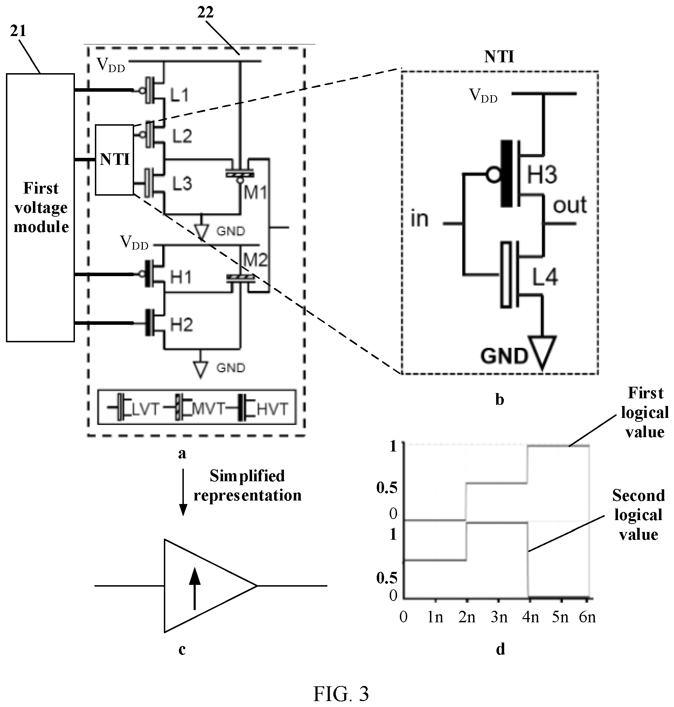

Refer to a in FIG. 3. The first voltage module 21 is separately connected to a gate of the first transistor L1, a gate of the fourth transistor H1, and a gate of the fifth transistor H2, and the NTI is separately connected to a gate of the second transistor L2 and a gate of the third transistor L3. A source of the first transistor L1 is connected to the second voltage module, a drain of the first transistor L1 is connected to a source of the second transistor L2, a drain of the second transistor L2 is separately connected to a source of the third transistor L3 and a source of the sixth transistor M1, and a drain of the third transistor L3 is grounded. A gate of the sixth transistor M1 is grounded, and a drain of the sixth transistor M1 is connected to a drain of the seventh transistor M2.

A source of the fourth transistor H1 is connected to the second voltage module, a drain of the fourth transistor H1 is separately connected to a source of the fifth transistor H2 and a source of the seventh transistor M2, a drain of the fifth transistor H2 is grounded, and a gate of the seventh transistor M2 is connected to the second voltage module.

It should be understood that, in a in FIG. 3, GND indicates grounding, in indicates output, out indicates output, and $V_{DD}$ indicates the second voltage module.

In this embodiment of this application, because the second voltage module may provide the fifth voltage ($V_{DD}$) for the logic gate module 22, and a ground voltage is $V_{GND}$, it may be understood that a highest voltage input to the logic gate module 22 is $V_{DD}$, and a lowest voltage input to the logic gate module 22 is $V_{GND}$. To reflect that the first voltage output by the first voltage module indicates any logical value in the ternary logical values, in some embodiments, when the first voltage is set to $V_{DD}$, the first voltage may indicate the first logical value 2; when the first voltage is set to $\frac{V_{DD}}{2}$, the first voltage may indicate the first logical value 1; and when the first voltage is set to $V_{GND}$, the first voltage may indicate the first logical value 0.

When the first voltage is equal to $V_{DD}$ (for example, 1 V), a third voltage $V_{GND}$ (for example, 0 V) may be output after the first voltage passes through the NTI, where the third voltage indicates a third logical value 0. When the first voltage is equal to $\frac{V_{DD}}{2}$ (for example, 0.5 V), a third voltage $V_{GND}$ (for example, 0 V) may be output after the first voltage passes through the NTI, where the third voltage indicates the third logical value 0. When the first voltage is equal to $V_{GND}$ (for example, 0 V), a third voltage $V_{DD}$ (for example, 1 V) may be output after the first voltage passes through the NTI, where the third voltage indicates a third logical value 2. In conclusion, the NTI is configured to: receive the first voltage, and output the third voltage, where the third voltage value indicates the third logical value 0 or the third logical value 2.

Refer to b in FIG. 3. The NTI may be formed by two transistors connected in parallel, and the two transistors are respectively an eighth transistor H3 and a ninth transistor L4. A threshold voltage of the eighth transistor H3 is greater than the second threshold, and a threshold voltage of the ninth transistor L4 may be less than or equal to the first threshold. The eighth transistor H3 is a P-type transistor, and the ninth transistor L4 is an N-type transistor. It should be understood that a connection between the NTI and the second voltage module is not shown in a in FIG. 3.

The first voltage module 21 is separately connected to a gate of the eighth transistor H3 and a gate of the ninth transistor L4, a source of the eighth transistor H3 is connected to the second voltage module, a drain of the eighth transistor H3 is connected to a source of the ninth transistor L4, and a drain of the ninth transistor L4 is grounded. A source of the ninth transistor L4 is separately connected to the gate of the second transistor L2 and the gate of the third transistor L3.

In some embodiments, the ternary logic gate circuit shown in a in FIG. 3 may be referred to as an auto-addition logic gate circuit or a first ternary logic gate circuit. The auto-addition logic gate circuit can implement that the second logical value is equal to the first logical value plus 1. If the first voltage indicates that the first logical value is 0, the ternary logic gate circuit outputs a second logical value 1. If the first voltage indicates that the first logical value is 1, the ternary logic gate circuit outputs a second logical value 2. If the first voltage indicates that the first logical value is 2, the ternary logic gate circuit outputs a second logical value 0.

In some embodiments, the auto-addition logic gate circuit may be simplified and represented as c in FIG. 3. In a more complex ternary logic circuit (such as an adder circuit and a half-adder circuit) provided in the following embodiments, the auto-addition logic gate circuit may be represented by using a simplified schematic shown in c in FIG. 3.

In some embodiments, the fifth voltage may be 0.9 V to 1.8 V, or even a value greater than 1.8 V.

In some embodiments, the first threshold voltage may be set to 0.2 V to 0.3 V, the third threshold voltage may be set to 0.4 V, and the second threshold voltage may be set to 0.6 V to 0.7 V. In some embodiments, a sum of the first threshold voltage and the second threshold voltage may be less than the fifth voltage.

With reference to FIG. 3, the following describes a principle that the second logical value is equal to the first logical value plus 1. In the following example, $V_{DD}$ is 1 V, and $V_{GND}$ is 0 V.

First, when the first voltage is equal to $V_{GND}$, the first voltage indicates the first logical value 0.

For the first transistor L1, a voltage at the gate of the first transistor L1 is $V_{GND}$, a voltage at the source of the first transistor L1 is $V_{DD}$, and a voltage difference between the gate and the source of the first transistor L1 is $V_{GND}$-$V_{DD}$ (for example, -1 V). In addition, because the first transistor L1 is a P-type transistor, and an absolute value (for example, 1 V) of the voltage difference between the gate and the source of the first transistor L1 is greater than the first threshold voltage of the first transistor L1, the first transistor L1 is turned on.

When the first transistor L1 is turned on, a voltage at the source of the second transistor L2 is equal to $V_{DD}$, and the third voltage $V_{DD}$ may be output after the first voltage ($V_{GND}$) passes through the NTI. Therefore, a voltage at the gate of the second transistor L2 is $V_{DD}$. A voltage difference between the gate and the source of the second transistor L2 is 0 V. In addition, because the second transistor L2 is a P-type transistor, and an absolute value of the voltage difference between the gate and the source of the second transistor L2 is less than the first threshold voltage of the second transistor L2, the second transistor L2 is turned off.

Similarly, for the third transistor L3, the third voltage $V_{DD}$ may be output after the first voltage ($V_{GND}$) passes through the NTI, and a voltage at the gate of the third transistor L3 is $V_{DD}$. The drain of the third transistor L3 is grounded, and a voltage difference between the gate and the drain of the third transistor L3 is $V_{DD}$ (for example, 1 V). In addition, because the third transistor L3 is an N-type transistor, and the voltage difference (for example, 1 V) between the gate and the drain of the third transistor L3 is greater than the first threshold voltage of the third transistor L3, the third transistor L3 is turned on.

When the third transistor L3 is turned on, a voltage at the source of the sixth transistor M1 is equal to $V_{DD}$. Because the gate of the sixth transistor M1 is grounded, a voltage difference between the gate and the source of the sixth transistor M1 is $V_{GND}$-$V_{DD}$ (for example, -1 V). In addition, because the sixth transistor M1 is a P-type transistor, and an absolute value (for example, 1 V) of the voltage difference between the gate and the source of the sixth transistor M1 is greater than the third threshold voltage of the sixth transistor M1, the sixth transistor M1 is turned on.

Similarly, for the fourth transistor H1, a voltage at the gate of the fourth transistor H1 is $V_{GND}$, a voltage at the source of the fourth transistor H1 is $V_{DD}$, and a voltage difference between the gate and the source of the fourth transistor H1 is $V_{GND}$-$V_{DD}$ (for example, -1 V). In addition, because the fourth transistor H1 is a P-type transistor, and an absolute value (for example, 1 V) of the voltage difference between the gate and the source of the fourth transistor H1 is greater than the second threshold voltage of the fourth transistor H1, the fourth transistor H1 is turned on.

A voltage at the source of the fifth transistor H2 is equal to $V_{GND}$. Because a voltage at the gate of the fifth transistor H2 is $V_{GND}$, a voltage difference between the gate and the source of the fifth transistor H2 is 0. In addition, because the fifth transistor H2 is an N-type transistor, and the voltage difference between the gate and the source of the fifth transistor H2 is less than the second threshold voltage of the fifth transistor H2, the fifth transistor H2 is turned off.

When the fourth transistor H1 is turned on, a voltage at the source of the seventh transistor M2 is equal to $V_{GND}$. Because the gate of the seventh transistor M2 is connected to the second voltage module, a voltage at the gate of the seventh transistor M2 is $V_{DD}$, and a voltage difference between the gate and the source of the seventh transistor M2 is $V_{DD}$-$V_{GND}$ (for example, 1 V). In addition, because the seventh transistor M2 is an N-type transistor, and the voltage difference between the gate and the source of the seventh transistor M2 is greater than the third threshold voltage of the seventh transistor M2, the seventh transistor M2 is turned on.

When the sixth transistor M1 and the seventh transistor M2 are turned on, a second voltage $\dfrac{V_{DD}}{2}$ may be output, where the second voltage indicates the second logical value 1. Specifically, when both the sixth transistor M1 and the seventh transistor M2 are turned on, a voltage output by the ternary logic gate circuit is equivalent to a voltage divided by series resistances of the sixth transistor M1 and the seventh transistor M2, that is, the voltage output by the ternary logic gate circuit $V_{out}=R_{M2}/(R_{M1}+R_{M2})\times V_{DD}$. In this case, $R_{M1}$ and $R_{M2}$ are almost equal. Therefore, the ternary logic gate circuit outputs $\dfrac{V_{DD}}{2}$. $R_{M1}$ is a resistance of the sixth transistor M1, and $R_{M2}$ is a resistance of the seventh transistor M2.

In conclusion, when the first voltage is equal to $V_{GND}$, the first voltage indicates the first logical value 0, and in the ternary logic gate circuit, the first transistor L1 is turned on, the second transistor L2 is turned off, the third transistor L3 is turned on, the fourth transistor H1 is turned on, the fifth transistor H2 is turned off, the sixth transistor M1 is turned on, and the seventh transistor M2 is turned on. The first group of transistors (the first transistor L1, the second transistor L2, and the third transistor L3) may output $V_{DD}$ to the third group of transistors (for example, the sixth transistor M1), where $V_{DD}$ indicates a logical value 2. In addition, the second group of transistors (the fourth transistor H1 and the fifth transistor H2) may output $V_{GND}$ to the third group of transistors (for example, the seventh transistor M2), where $V_{GND}$ indicates a logical value 0. Therefore, the first group of transistors and the second group of transistors are considered as the first processing unit, and the first processing unit may output the fourth voltage that indicates the fourth logical value, where the fourth logical value includes 0 and 2.

Second, when the first voltage is equal to $\dfrac{V_{DD}}{2}$, the first voltage indicates the first logical value 1.

For the first transistor L1, a voltage at the gate of the first transistor L1 is $\dfrac{V_{DD}}{2}$, a voltage at the source of the first transistor L1 is $V_{DD}$, and a voltage difference between the gate and the source of the first transistor L1 is $\dfrac{V_{DD}}{2}-V_{DD}$ (for example, -0.5 V). In addition, because the first transistor L1 is a P-type transistor, and an absolute value (for example, 0.5 V) of the voltage difference between the gate and the source of the first transistor L1 is greater than the first threshold voltage of the first transistor L1, the first transistor L1 is turned on.

When the first transistor L1 is turned on, a voltage at the source of the second transistor L2 is equal to $V_{DD}$, and the third voltage $V_{GND}$ may be output after the first voltage ($\dfrac{V_{DD}}{2}$) passes through the NTI. Therefore, a voltage at the gate of the second transistor L2 is $V_{GND}$. A voltage difference between the gate and the source of the second transistor L2 is $V_{GND}$-$V_{DD}$ (for example, -1 V). In addition, because the second transistor L2 is a P-type transistor, and an absolute value (for example, 1 V) of the voltage difference between the gate and the source of the second transistor L2 is greater than the first threshold voltage of the second transistor L2, the second transistor L2 is turned on.

For the third transistor L3, the third voltage $V_{GND}$ may be output after the first voltage ($\dfrac{V_{DD}}{2}$) passes through the NTI, and a voltage at the gate of the third transistor L3 is $V_{GND}$. The drain of the third transistor L3 is grounded, and a voltage difference between the gate and the drain of the third transistor L3 is 0 V. In addition, because the third transistor L3 is an N-type transistor, and the voltage difference between the gate and the drain of the third transistor L3 is less than the first threshold voltage of the third transistor L3, the third transistor L3 is turned off.

When the second transistor L2 is turned on, a voltage at the source of the sixth transistor M1 is equal to $V_{DD}$. Because the gate of the sixth transistor M1 is grounded, a voltage difference between the gate and the source of the sixth transistor M1 is 0-$V_{DD}$ (for example, -1 V). In addition, because the sixth transistor M1 is a P-type transistor, and an absolute value (for example, 1 V) of the voltage difference between the gate and the source of the sixth transistor M1 is greater than the third threshold voltage of the sixth transistor M1, the sixth transistor M1 is turned on.

Similarly, for the fourth transistor H1, a voltage at the gate of the fourth transistor H1 is $\dfrac{V_{DD}}{2}$, a voltage at the source of the fourth transistor H1 is $V_{DD}$, and a voltage difference between the gate and the source of the fourth transistor H1 is $\dfrac{V_{DD}}{2}$ $-V_{DD}$ (for example, -0.5 V). In addition, because the fourth transistor H1 is a P-type transistor, and an absolute value (for example, 0.5 V) of the voltage difference between the gate and the source of the fourth transistor H1 is less than the second threshold voltage (for example, 0.6 V to 0.7 V) of the fourth transistor H1, the fourth transistor H1 is turned off.

Similarly, a voltage at the drain of the fifth transistor H2 is equal to $V_{GND}$. Because a voltage at the gate of the fifth transistor H2 is $\dfrac{V_{DD}}{2}$, a voltage difference between the gate and the drain of the fifth transistor H2 is $\dfrac{V_{DD}}{2}$ $-V_{GND}$ (for example, 0.5 V). In addition, because the fifth transistor H2 is an N-type transistor, and the voltage difference (for example, 0.5 V) between the gate and the source of the fifth transistor H2 is less than the second threshold voltage (for example, 0.6 V to 0.7 V) of the fifth transistor H2, the fifth transistor H2 is turned off.

When both the fourth transistor H2 and the fifth transistor H2 are turned off, a voltage at the source of the seventh transistor M2 is equal to 0 V. Because the gate of the seventh transistor M2 is connected to the second voltage module, a voltage at the gate of the seventh transistor M2 is $V_{DD}$, and a voltage difference between the gate and the source of the seventh transistor M2 is $V_{DD}$ (for example, 1 V). In addition, because the seventh transistor M2 is an N-type transistor, and the voltage difference between the gate and the source of the seventh transistor M2 is greater than the third threshold voltage of the seventh transistor M2, the seventh transistor M2 is turned on.

According to a same analysis idea, when the sixth transistor M1 and the seventh transistor M2 are turned on, the second voltage $V_{DD}$ may be output, where the second voltage indicates the second logical value 2.

In conclusion, when the first voltage is equal to $\dfrac{V_{DD}}{2}$, the first voltage indicates the first logical value 1, and in the ternary logic gate circuit, the first transistor L1 is turned on, the second transistor L2 is turned on, the third transistor L3 is turned off, the fourth transistor H1 is turned off, the fifth transistor H2 is turned off, the sixth transistor M1 is turned on, and the seventh transistor M2 is turned on. The first group of transistors (the first transistor L1, the second transistor L2, and the third transistor L3) may output $V_{DD}$ to the third group of transistors (for example, the sixth transistor M1), where $V_{DD}$ indicates a logical value 2. In addition, the second group of transistors (the fourth transistor H1 and the fifth transistor H2) may output $V_{GND}$ to the third group of transistors (for example, the seventh transistor M2), where $V_{GND}$ indicates a logical value 0. Therefore, the first group of transistors and the second group of transistors are considered as the first processing unit, and the first processing unit may output the fourth voltage that indicates the fourth logical value, where the fourth logical value includes 0 and 2.

Third, when the first voltage is equal to $V_{DD}$, the first voltage indicates the first logical value 2.

For the first transistor L1, a voltage at the gate of the first transistor L1 is $V_{DD}$, a voltage at the source of the first transistor L1 is $V_{DD}$, and a voltage difference between the gate and the source of the first transistor L1 is 0. In addition, because the first transistor L1 is a P-type transistor, and an absolute value of the voltage difference between the gate and the source of the first transistor L1 is less than the first threshold voltage of the first transistor L1, the first transistor L1 is turned off.

For the third transistor L3, the third voltage $V_{GND}$ may be output after the first voltage ($V_{DD}$) passes through the NTI, and a voltage at the gate of the third transistor L3 is $V_{GND}$. The drain of the third transistor L3 is grounded, and a voltage difference between the gate and the source of the third transistor L3 is 0. In addition, because the third transistor L3 is an N-type transistor, and the voltage difference between the gate and the source of the third transistor L3 is less than the first threshold voltage of the third transistor L3, the third transistor L3 is turned off.

For the second transistor L2, when both the first transistor L1 and the third transistor L3 are turned off, the second transistor L2 has no impact on the ternary logic gate circuit. In this case, the ternary logic gate circuit outputs a voltage $V_{GND}$ through the fifth transistor H2 and the seventh transistor M2, thereby implementing a function of adding 1 to the first logical value.

For the fourth transistor H1, a voltage at the gate of the fourth transistor H1 is $V_{DD}$, a voltage at the source of the fourth transistor H1 is $V_{DD}$, and a voltage difference between the gate and the source of the fourth transistor H1 is 0 V. In addition, because the fourth transistor H1 is a P-type transistor, and an absolute value of the voltage difference between the gate and the source of the fourth transistor H1 is less than the second threshold voltage of the fourth transistor H1, the fourth transistor H1 is turned off.

A voltage at the drain of the fifth transistor H2 is equal to $V_{GND}$, and a voltage at the gate of the fifth transistor H2 is $V_{DD}$. Therefore, a voltage difference between the gate and the source of the fifth transistor H2 is $V_{DD}$-$V_{GND}$ (for example, 1 V). In addition, because the fifth transistor H2 is an N-type transistor, and the voltage difference between the gate and the source of the fifth transistor H2 is greater than the second threshold voltage of the fifth transistor H2, the fifth transistor H2 is turned on.

When the fifth transistor H2 is turned on, a voltage at the source of the seventh transistor M2 is equal to $V_{GND}$. Because the gate of the seventh transistor M2 is connected to the second voltage module, a voltage at the gate of the seventh transistor M2 is $V_{DD}$, and a voltage difference between the gate and the source of the seventh transistor M2 is $V_{DD}$ (for example, 1 V). In addition, because the seventh transistor M2 is an N-type transistor, and the voltage difference between the gate and the source of the seventh transistor M2 is greater than the third threshold voltage of the seventh transistor M2, the seventh transistor M2 is turned on.

According to a same analysis idea, when the sixth transistor M1 and the seventh transistor M2 are turned on, the second voltage $V_{GND}$ may be output, where the second voltage indicates the second logical value 0. Specifically, because the first transistor L1 and the third transistor L3 are turned off, the second transistor L2 and the sixth transistor M1 are isolated from the circuit, and have no impact on the ternary logic gate circuit. In this case, the ternary logic gate circuit outputs $V_{GND}$ through H2 and M2, thereby implementing a function of adding 1 to the first logical value.

In conclusion, when the first voltage is equal to $V_{DD}$, the first voltage indicates the first logical value 2, and in the ternary logic gate circuit, the first transistor L1 is turned off, the second transistor L2 is turned on, the third transistor L3 is turned off, the fourth transistor H1 is turned off, the fifth transistor H2 is turned on, the sixth transistor M1 is turned on, and the seventh transistor M2 is turned on. The first group of transistors (the first transistor L1, the second transistor L2, and the third transistor L3) may output $V_{DD}$ to the third group of transistors (for example, the sixth transistor M1), where $V_{DD}$ indicates a logical value 2. In addition, the second group of transistors (the fourth transistor H1 and the fifth transistor H2) may output $V_{GND}$ to the third group of transistors (for example, the seventh transistor M2), where $V_{GND}$ indicates a logical value 0. Therefore, the first group of transistors and the second group of transistors are considered as the first processing unit, and the first processing unit may output the fourth voltage that indicates the fourth logical value, where the fourth logical value includes 0 and 2.

Refer to d in FIG. 3. In conclusion, when the input first voltage is $V_{GND}$=0 V, that is, when the first logical value is 0, the output second voltage is $\dfrac{V_{DD}}{2}$, that is, the second logical value is 1; when the input first voltage is $\dfrac{V_{DD}}{2}=0.5$ V, that is, when the first logical value is 1, the output second voltage is $V_{DD}$=1 V, that is, the second logical value is 2; and when the input first voltage is $V_{DD}$=1 V, that is, when the first logical value is 2, the output second voltage is $V_{GND}$=0 V, that is, the second logical value is 0.

In conclusion, Table 1 shows turn-on/off states of the first transistor L1, the second transistor L2, the third transistor L3, the fourth transistor H1, the fifth transistor H2, the sixth transistor M1, and the seventh transistor M2 when the first voltage is $V_{GND}$, $\dfrac{V_{DD}}{2}$, and $V_{DD}$.

Table 1

| First voltage | First transistor L1 | Second transistor L2 | Third transistor L3 | Fourth transistor H1 | Fifth transistor H2 | Sixth transistor M1 | Seventh transistor M2 |
|---|---|---|---|---|---|---|---|
| $V_{GND}$ | ON | OFF | ON | ON | OFF | ON | ON |
| $\dfrac{V_{DD}}{2}$ | ON | ON | OFF | OFF | OFF | ON | ON |
| $V_{DD}$ | OFF | ON | OFF | OFF | ON | ON | ON |

ON in Table 1 indicates that a transistor is turned on, and OFF indicates that a transistor is turned off.

It should be understood that, in this embodiment of this application, turn-on/off states of the transistors at different inputs are analyzed, and based on the turn-on/off states of the transistors, the ternary gate circuit can output different second voltages (that is, different outputs), and the second logical value is equal to the first logical value plus 1. It should be noted that, when a transistor is turned off, an adjacent transistor is isolated from the circuit, and does not affect an output of the ternary logic gate circuit. When an output of the ternary gate circuit is analyzed, specific analysis may be performed with reference to the ternary logic gate circuit shown in a in FIG. 3.

Example 2: The ternary logic gate circuit can subtract 1 from the first logical value, that is, the second logical value is equal to the first logical value minus 1.

In some embodiments, the preprocessing module 221 is a positive ternary inverter (positive ternary inverter, PTI); and the first group of transistors includes a first transistor L1, a second transistor L2, and a third transistor L3, the second group of transistors includes a fourth transistor H1 and a fifth transistor H2, and the third group of transistors includes a sixth transistor M1 and a seventh transistor M2.

In some embodiments, the first group of transistors, the second group of transistors, and the third group of transistors may use transistors of a same polarity or different polarities, and the polarities may include an N-type and a P-type. In some embodiments, the first transistor L1, the fourth transistor H1, and the sixth transistor M1 are P-type transistors, and the second transistor L2, the third transistor L3, the fifth transistor H2, and the seventh transistor M2 are N-type transistors.

In some embodiments, the ternary logic gate circuit may further include a second voltage module, and the second voltage module may provide a fifth voltage ($V_{DD}$) for the logic gate module 22.

In some embodiments, the first voltage module 21 and the second voltage module may not be included in the ternary logic gate circuit. The ternary logic gate circuit may receive the first voltage from the first voltage module 21 and the fifth voltage from the second voltage module.

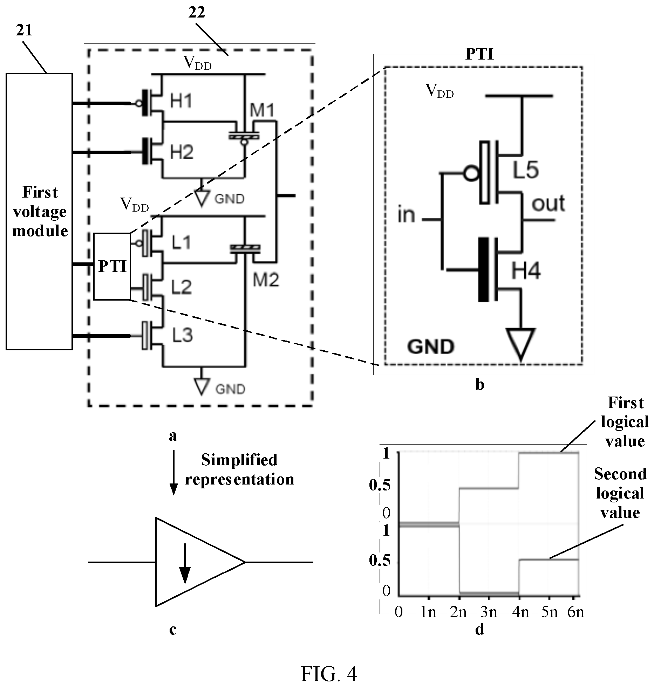

Refer to a in FIG. 4. The first voltage module 21 is separately connected to a gate of the third transistor L3, a gate of the fourth transistor H1, and a gate of the fifth transistor H2, and the PTI is separately connected to a gate of the first transistor L1 and a gate of the second transistor L2. A source of the first transistor L1 is connected to the second voltage module, and a drain of the first transistor L1 is separately connected to a source of the second transistor L2 and a source of the seventh transistor M2. A drain of the second transistor L2 is connected to a source of the third transistor L3, a drain of the third transistor L3 is grounded, a gate of the seventh transistor M2 is connected to the second voltage module, and a drain of the seventh transistor M2 is connected to a drain of the sixth transistor M1.

A source of the fourth transistor H1 is connected to the second voltage module, a drain of the fourth transistor H1 is separately connected to a source of the fifth transistor H2 and a source of the sixth transistor M1, a drain of the fifth transistor H2 is grounded, and a gate of the sixth transistor M1 is grounded.

It should be understood that GND in a in FIG. 4 represents grounding.

In some embodiments, when the first voltage is set to $V_{DD}$, the first voltage may indicate a first logical value 2; when the first voltage is set to $\dfrac{V_{DD}}{2}$, the first voltage may indicate a first logical value 1; and when the first voltage is set to $V_{GND}$, the first voltage may indicate a first logical value 0.

When the first voltage is equal to $V_{DD}$, a third voltage $V_{GND}$ may be output after the first voltage passes through the PTI, where the third voltage indicates a third logical value 0. When the first voltage is equal to $\dfrac{V_{DD}}{2}$, a third voltage $V_{DD}$ may be output after the first voltage passes through the PTI, where the third voltage indicates a third logical value 2. When the first voltage is equal to $V_{GND}$, a third voltage $V_{DD}$ may be output after the first voltage passes through the NTI, where the third voltage indicates a third logical value 2. In conclusion, the PTI is configured to: receive the first voltage, and output the third voltage, where the third voltage value indicates the third logical value 0 or 2.

Refer to b in FIG. 4. The PTI may include two transistors connected in parallel, and the two transistors are respectively a tenth transistor L5 and an eleventh transistor H4. A threshold voltage of the eleventh transistor H4 is greater than a second threshold, and a threshold voltage of the tenth transistor L5 is less than a first threshold. The tenth transistor L5 is a P-type transistor, and the eleventh transistor H4 is an N-type transistor.

The first voltage module 21 is separately connected to a gate of the tenth transistor L5 and a gate of the eleventh transistor H4, a source of the tenth transistor L5 is connected to the second voltage module, a drain of the tenth transistor L5 is connected to a source of the eleventh transistor H4, and a drain of the eleventh transistor H4 is grounded. A source of the eleventh transistor H4 is separately connected to a gate of the first transistor L1 and a gate of the second transistor L2.

In some embodiments, the ternary logic gate circuit shown in a in FIG. 4 may be referred to as an auto-substraction logic gate circuit or a second ternary logic gate circuit, and can implement that the second logical value is equal to the first logical value minus 1. If the first voltage indicates that the first logical value is 0, the ternary logic gate circuit outputs a second logical value 2. If the first voltage indicates that the first logical value is 1, the ternary logic gate circuit outputs a second logical value 0. If the first voltage indicates that the first logical value is 2, the ternary logic gate circuit outputs a second logical value 1.

In some embodiments, the auto-addition logic gate circuit may be simplified and represented as shown in c in FIG. 4. In a more complex ternary logic circuit (such as an adder circuit and a half-adder circuit) provided in the following embodiments, the auto-addition logic gate circuit may be represented by using a simplified schematic shown in b in FIG. 4.

In some embodiments, the fifth voltage may be 0.9 V to 1.8 V, or even a value greater than 1.8 V.

In some embodiments, the first threshold voltage may be set to 0.2 V to 0.3 V, the third threshold voltage may be set to 0.4 V, and the second threshold voltage may be set to 0.6 V to 0.7 V. In some embodiments, a sum of the first threshold voltage and the second threshold voltage may be less than the fifth voltage.

Based on a same analysis idea in "first" to "third", the following describes, with reference to the auto-substraction logic gate circuit shown in a in FIG. 4, a principle that the second logical value is equal to the first logical value minus 1.

Fourth, when the first voltage is equal to $V_{GND}$, the first voltage indicates the first logical value 0.

For the first transistor L1, the third voltage $V_{DD}$ may be output after the first voltage ($V_{GND}$) passes through the PTI, a voltage at the gate of the first transistor L1 is $V_{DD}$, a voltage at the source of the first transistor L1 is $V_{DD}$, and a voltage difference between the gate and the source of the first transistor L1 is 0. In addition, because the first transistor L1 is a P-type transistor, and an absolute value of the voltage difference between the gate and the source of the first transistor L1 is less than the first threshold voltage of the first transistor L1, the first transistor L1 is turned off.

For the third transistor L3, a voltage at the gate of the third transistor L3 is $V_{GND}$, the drain of the third transistor L3 is grounded, and a voltage difference between the gate and the drain of the third transistor L3 is 0. In addition, because the third transistor L3 is an N-type transistor, and the voltage difference between the gate and the drain of the third transistor L3 is less than the first threshold voltage of the third transistor L3, the third transistor L3 is turned off.

When the first transistor L1 is turned on, a voltage at the source of the second transistor L2 is 0. For the second transistor L2, the third voltage $V_{DD}$ may be output after the first voltage ($V_{GND}$) passes through the PTI, a voltage at the gate of the second transistor L2 is $V_{DD}$, and a voltage difference between the gate and the source of the second transistor L2 is $V_{DD}$. In addition, because the second transistor L2 is an N-type transistor, and the voltage difference between the gate and the source of the second transistor L2 is greater than the first threshold voltage of the second transistor L2, the second transistor L2 is turned on.

When the second transistor L2 is turned on, a voltage at the source of the seventh transistor M2 is equal to $V_{GND}$. Because the gate of the seventh transistor M2 is connected to the second voltage module, a voltage at the gate of the seventh transistor M2 is $V_{DD}$. In addition, because the seventh transistor M2 is an N-type transistor, and a voltage difference ($V_{DD}$-$V_{GND}$) between the gate and the source of the seventh transistor M2 is greater than the third threshold voltage of the seventh transistor M2, the seventh transistor M2 is turned on.

Similarly, for the fourth transistor H1, a voltage at the gate of the fourth transistor H1 is $V_{GND}$, a voltage at the source of the fourth transistor H1 is $V_{DD}$, and a voltage difference between the gate and the source of the fourth transistor H1 is $V_{GND}$-$V_{DD}$ (for example, -1 V). In addition, because the fourth transistor H1 is a P-type transistor, and an absolute value (for example, 1 V) of the voltage difference between the gate and the source of the fourth transistor H1 is greater than the second threshold voltage of the fourth transistor H1, the fourth transistor H1 is turned on.

When the fourth transistor H1 is turned on, a voltage at the source of the fifth transistor H2 is equal to $V_{GND}$. Because a voltage at the gate of the fifth transistor H2 is $V_{GND}$, a voltage difference between the gate and the source of the fifth transistor H2 is 0 V. In addition, because the fifth transistor H2 is an N-type transistor, and the voltage difference between the gate and the source of the fifth transistor H2 is less than the second threshold voltage of the fifth transistor H2, the fifth transistor H2 is turned off.

When the fourth transistor H1 is turned on, a voltage at the source of the sixth transistor M1 is equal to $V_{DD}$. Because the gate of the sixth transistor M1 is grounded, a voltage at the gate of the sixth transistor M1 is $V_{GND}$, and a voltage difference between the gate and the source of the sixth transistor M1 is $V_{DD}$-$V_{GND}$. In addition, because the sixth transistor M1 is a P-type transistor, and an absolute value of the voltage difference between the gate and the source of the sixth transistor M1 is greater than the third threshold voltage of the sixth transistor M1, the sixth transistor M1 is turned on.

When the sixth transistor M1 and the seventh transistor M2 are turned on, the second voltage $V_{DD}$ may be output, where the second voltage indicates the second logical value 2.

In conclusion, when the first voltage is equal to $V_{GND}$, the first voltage indicates the first logical value 0, and in the ternary logic gate circuit, the first transistor L1 is turned off, the second transistor L2 is turned on, the third transistor L3 is turned off, the fourth transistor H1 is turned on, the fifth transistor H2 is turned off, the sixth transistor M1 is turned on, and the seventh transistor M2 is turned on. In this case, only the fourth transistor H1 and the sixth transistor M1 in the circuit are used to transmit $V_{DD}$ to an output end. Therefore, when the input first logical value is 0, the output second logical value is 2, thereby implementing a function of subtracting 1.

Fifth, when the first voltage is equal to $\dfrac{V_{DD}}{2}$ , the first voltage indicates the first logical value 1.

For the first transistor L1, a third voltage $V_{DD}$ may be output after the first voltage ( $\dfrac{V_{DD}}{2}$ ) passes through the PTI, a voltage at the gate of the first transistor L1 is $V_{DD}$, a voltage at the source of the first transistor L1 is $V_{DD}$, and a voltage difference between the gate and the source of the first transistor L1 is 0. In addition, because the first transistor L1 is a P-type transistor, and an absolute value of the voltage difference between the gate and the source of the first transistor L1 is less than the first threshold voltage of the first transistor L1, the first transistor L1 is turned off.

For the third transistor L3, the gate of the third transistor L3 is $\dfrac{V_{DD}}{2}$ , a voltage at the drain of the third transistor L3 is $V_{GND}$, and a voltage difference between the gate and the drain of the third transistor L3 is $\dfrac{V_{DD}}{2} - V_{GND}$ (for example, 0.5 V). In addition, because the third transistor L3 is an N-type transistor, and the voltage difference between the gate and the drain of the third transistor L3 is greater than the first threshold voltage of the third transistor L3, the third transistor L3 is turned on.

When the third transistor L3 is turned on, a voltage at the source of the second transistor L2 is 0 V, the third voltage $V_{DD}$ may be output after the first voltage ( $\dfrac{V_{DD}}{2}$ ) passes through the PTI, a voltage at the gate of the second transistor L2 is $V_{DD}$, and a voltage difference between the gate and the source of the second transistor L2 is $\dfrac{V_{DD}}{2}$ . In addition, because the second transistor L2 is an N-type transistor, and the voltage difference between the gate and the source of the second transistor L2 is greater than the first threshold voltage of the second transistor L2, the second transistor L2 is turned on.

When the second transistor L2 is turned on, a voltage at the source of the seventh transistor M2 is equal to $\dfrac{V_{DD}}{2}$ . Because the gate of the seventh transistor M2 is connected to the second voltage module, a voltage at the gate of the seventh transistor M2 is $V_{DD}$. In addition, because the seventh transistor M2 is an N-type transistor, and a voltage difference between the gate and the source of the seventh transistor M2 is greater than the third threshold voltage of the seventh transistor M2, the seventh transistor M2 is turned on.

Similarly, for the fourth transistor H1, a voltage at the gate of the fourth transistor H1 is $\dfrac{V_{DD}}{2}$ , a voltage at the source of the fourth transistor H1 is $V_{DD}$, and a voltage difference between the gate and the source of the fourth transistor H1 is $\dfrac{V_{DD}}{2} - V_{DD}$ (for example, -0.5 V). In addition, because the fourth transistor H1 is a P-type transistor, and an absolute value (for example, 0.5 V) of the voltage difference between the gate and the source of the fourth transistor H1 is less than the second threshold voltage (for example, 0.6 V to 0.7 V) of the fourth transistor H1, the fourth transistor H1 is turned off.

Similarly, for the fifth transistor H2, a voltage at the gate of the fifth transistor H2 is $\dfrac{V_{DD}}{2}$ , a voltage at the drain of the fifth transistor H2 is equal to $V_{GND}$, and a voltage difference between the gate and the drain of the fifth transistor H2 is

$\dfrac{V_{DD}}{2} - V_{\text{GND}}$ (for example, 0.5 V). In addition, because the fifth transistor H2 is an N-type transistor, and the voltage difference (for example, 0.5 V) between the gate and the source of the fifth transistor H2 is less than the second threshold voltage (for example, 0.6 V to 0.7 V) of the fifth transistor H2, the fifth transistor H2 is turned off.

When both the fourth transistor H1 and the fifth transistor are turned off, the sixth transistor M1 is isolated from the ternary logic gate circuit, and does not affect an output of the ternary logic gate circuit.

When the sixth transistor M1 and the seventh transistor M2 are turned on, the third transistor L3, the second transistor L2, and the seventh transistor M2 in the ternary logic gate circuit are used to implement that an input is $\dfrac{V_{DD}}{2}$ and an output is 0 V, thereby subtracting 1 from the first logical value. In this embodiment of this application, when the first voltage is $\dfrac{V_{DD}}{2}$, the ternary logic gate circuit may output the second voltage $V_{\text{GND}}$, where the second voltage indicates the second logical value 0.

In conclusion, when the first voltage is equal to $\dfrac{V_{DD}}{2}$, the first voltage indicates the first logical value 1, and in the ternary logic gate circuit, the first transistor L1 is turned off, the second transistor L2 is turned on, the third transistor L3 is turned on, the fourth transistor H1 is turned off, the fifth transistor H2 is turned off, the sixth transistor M1 is turned on, and the seventh transistor M2 is turned on.

Sixth, when the first voltage is equal to $V_{DD}$, the first voltage indicates the first logical value 2.

For the first transistor L1, a third voltage $V_{\text{GND}}$ may be output after the first voltage ($V_{DD}$) passes through the PTI, a voltage at the gate of the first transistor L1 is $V_{\text{GND}}$, a voltage at the source of the first transistor L1 is $V_{DD}$, and a voltage difference between the gate and the source of the first transistor L1 is $V_{\text{GND}}$-$V_{DD}$ (for example, -1 V). In addition, because the first transistor L1 is a P-type transistor, and an absolute value (for example, 1 V) of the voltage difference between the gate and the source of the first transistor L1 is greater than the first threshold voltage of the first transistor L1, the first transistor L1 is turned on.

For the third transistor L3, a voltage at the gate of the third transistor L3 is $V_{DD}$, a drain of the third transistor L3 is grounded, and a voltage difference between the gate and the drain of the third transistor L3 is $V_{DD}$. In addition, because the third transistor L3 is an N-type transistor, and the voltage difference between the gate and the source of the third transistor L3 is greater than the first threshold voltage of the third transistor L3, the third transistor L3 is turned on.

When both the first transistor L1 and the third transistor L3 are turned on, a voltage at the source of the second transistor L2 is $V_{\text{GND}}$. For the second transistor L2, the third voltage $V_{\text{GND}}$ may be output after the first voltage ($V_{DD}$) passes through the PTI, a voltage at the gate of the second transistor L2 is $V_{\text{GND}}$, and a voltage difference between the gate and the source of the second transistor L2 is 0 V. In addition, because the second transistor L2 is an N-type transistor, and the voltage difference between the gate and the source of the second transistor L2 is less than the first threshold voltage of the second transistor L2, the second transistor L2 is turned off.

After the second transistor L2 is turned off, the third transistor L3 is isolated, and does not affect an output of the ternary gate circuit.

When the first transistor L1 is turned on, a voltage at the source of the seventh transistor M2 is equal to $V_{\text{GND}}$. Because the gate of the seventh transistor M2 is connected to the second voltage module, a voltage at the gate of the seventh transistor M2 is $V_{DD}$. In addition, because the seventh transistor M2 is an N-type transistor, and a voltage difference between the gate and the source of the seventh transistor M2 is greater than the third threshold voltage of the seventh transistor M2, the seventh transistor M2 is turned on.

Similarly, for the fourth transistor H1, a voltage at the gate of the fourth transistor H1 is $V_{DD}$, a voltage at the source of the fourth transistor H1 is $V_{DD}$, and a voltage difference between the gate and the source of the fourth transistor H1 is 0 V. In addition, because the fourth transistor H1 is a P-type transistor, and an absolute value of the voltage difference between the gate and the source of the fourth transistor H1 is less than the second threshold voltage of the fourth transistor H1, the fourth transistor H1 is turned off.

A voltage at the gate of the fifth transistor H2 is $V_{DD}$, and a voltage at the drain of the fifth transistor H2 is equal to $V_{\text{GND}}$. Therefore, a voltage difference between the gate and the drain of the fifth transistor H2 is $V_{DD}$-$V_{\text{GND}}$ (for example, 1 V). In addition, because the fifth transistor H2 is an N-type transistor, and the voltage difference between the gate and the source of the fifth transistor H2 is greater than the second threshold voltage of the fifth transistor H2, the fifth transistor H2 is turned on.

When the fifth transistor H3 is turned on, a voltage at the source of the sixth transistor M1 is equal to $V_{DD}$. Because the gate of the sixth transistor M1 is grounded, a voltage at the gate of the sixth transistor M1 is $V_{\text{GND}}$, and a voltage difference between the gate and the source of the sixth transistor M1 is $V_{\text{GND}}$-$V_{DD}$ (for example, -1 V). In addition, because the sixth transistor M1 is a P-type transistor, and an absolute value (1 V) of the voltage difference between the gate and the source of the sixth transistor M1 is greater than the third threshold voltage of the sixth transistor M1, the sixth transistor M1 is turned on.

According to a same analysis idea, when the sixth transistor M1 and the seventh transistor M2 are turned on, the second voltage $\dfrac{V_{DD}}{2}$ may be output, where the second voltage indicates the second logical value 1.

In conclusion, when the first voltage is equal to $V_{DD}$, the first voltage indicates the first logical value 2, and in the ternary logic gate circuit, the first transistor L1 is turned on, the second transistor L2 is turned off, the third transistor L3 is turned on, the fourth transistor H1 is turned off, the fifth transistor H2 is turned on, the sixth transistor M1 is turned on, and the seventh transistor M2 is turned on.

Refer to d in FIG. 4. In conclusion, when the input first voltage is $V_{GND}$=0 V, that is, the first logical value is 0, the output second voltage is $V_{DD}$, that is, the second logical value is 2; when the input first voltage is $\dfrac{V_{DD}}{2}=0.5$ V, that is, the first logical value is 1, the output second voltage is $V_{GND}$=0 V, that is, the second logical value is 0; and when the input first voltage is $V_{DD}$=1 V, that is, the first logical value is 2, the output second voltage is $\dfrac{V_{DD}}{2}=0.5$ V, that is, the second logical value is 1.

In conclusion, Table 2 shows turn-on/off states of the first transistor L1, the second transistor L2, the third transistor L3, the fourth transistor H1, the fifth transistor H2, the sixth transistor M1, and the seventh transistor M2 when the first voltage is $V_{GND}$, $\dfrac{V_{DD}}{2}$, and $V_{DD}$.

Table 2

| First voltage | First transistor L1 | Second transistor L2 | Third transistor L3 | Fourth transistor H1 | Fifth transistor H2 | Sixth transistor M1 | Seventh transistor M2 |
|---|---|---|---|---|---|---|---|
| $V_{GND}$ | OFF | ON | OFF | ON | OFF | ON | ON |
| $\dfrac{V_{DD}}{2}$ | OFF | ON | ON | OFF | OFF | ON | ON |
| $V_{DD}$ | OFF | OFF | ON | OFF | ON | ON | ON |

In Table 2, ON indicates that a transistor is turned on, and OFF indicates that a transistor is turned off.

It should be understood that, in this embodiment of this application, turn-on/off states of the transistors at different inputs are analyzed, and based on the turn-on/off states of the transistors, the ternary gate circuit can output different second voltages (that is, different outputs), and the second logical value is equal to the first logical value minus 1. It should be noted that, when a transistor is turned off, an adjacent transistor is isolated from the circuit, and does not affect an output of the ternary logic gate circuit. When an output of the ternary gate circuit is analyzed, specific analysis may be performed with reference to the ternary logic gate circuit shown in a in FIG. 4.

In conclusion, an embodiment of this application may provide an auto-addition logic gate circuit, to add 1 to an input ternary logical value. In addition, an embodiment of this application further provides an auto-substraction logic gate circuit, to subtract 1 from an input ternary logical value.

Based on the ternary logic gate circuits provided in embodiments of this application, in embodiments of this application, an adder circuit is designed by using the ternary logic gate circuit. The adder circuit is configured to perform summation calculation on two signals. Both the two signals are ternary signals. In some embodiments, the adder circuit may be referred to as an adder.

In some embodiments, the adder circuit may include a first ternary logic gate circuit and a second ternary logic gate circuit. In the first ternary logic gate circuit, a second logical value is equal to a first logical value plus 1, and in the second ternary logic gate circuit, a second logical value is equal to a first logical value minus 1. The first ternary logic gate circuit may be understood as an auto-addition logic gate circuit, and the second ternary logic gate circuit may be understood as an auto-substraction logic gate circuit.

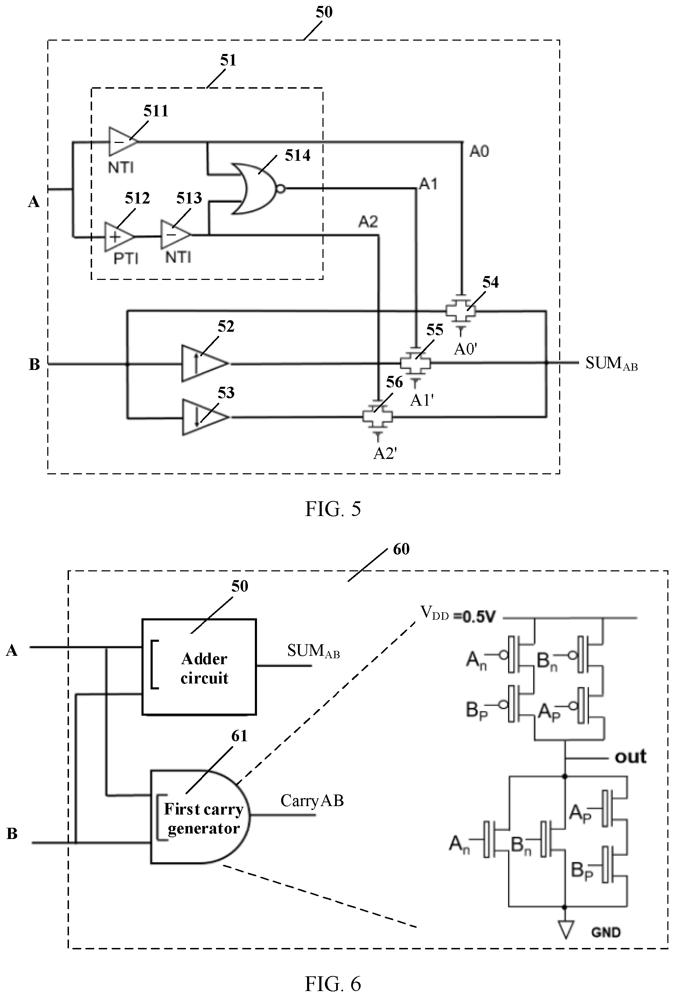

With reference to FIG. 5, the following describes the adder circuit provided in an embodiment of this application.

A first signal module is configured to connect to the adder circuit, and a second signal module is configured to connect to the adder circuit. The first signal module may output a first signal to the adder circuit, and the second signal module may output a second signal to the adder circuit. Both the first signal and the second signal are ternary signals. The adder circuit may perform summation calculation on the first signal and the second signal, and output a first summation result.

Refer to FIG. 5. In some embodiments, an adder circuit 50 may include a signal processing module 51, a first ternary logic gate circuit 52, a second ternary logic gate circuit 53, a first pass transistor 54, a second pass transistor 55, and a third pass transistor 56. In some embodiments, a pass transistor HIA may be referred to as a transmission gate.

In some embodiments, the adder circuit 50 may include a first signal module and a second signal module.

The signal processing module 51 is configured to connect to the first signal module, and the signal processing module 51 is separately connected to the first pass transistor 54, the second pass transistor 55, and the third pass transistor 56. The second signal module is configured to separately connect to the first pass transistor 54, the first ternary logic gate circuit 52, and the second ternary logic gate circuit 53. The first ternary logic gate circuit 52 is connected to the second pass transistor 55, and the second ternary logic gate circuit 53 is connected to the third pass transistor 56.

The second signal module is configured to output the second signal. When the second signal passes through the first ternary logic gate circuit 52, the first ternary logic gate circuit 52 may add 1 to a logical value corresponding to the second signal. When the second signal passes through the second ternary logic gate circuit 53, the second ternary logic gate circuit 53 may subtract 1 from a logical value corresponding to the second signal. When the second signal does not pass through the first ternary logic gate circuit 52 or the second ternary logic gate circuit 53, a logical value corresponding to the second signal may be output.

The first signal module is configured to output the first signal. The signal processing module 51 is configured to turn on any pass transistor based on the first signal, to enable the adder circuit to output the first summation result of the first signal and the second signal.

Both the first signal and the second signal are ternary signals. For example, the first signal indicates a fifth logical value, and the second signal indicates a sixth logical value. In some embodiments, the first signal module may output the first signal by outputting a voltage or a level, and the second signal module may also output the second signal by outputting a voltage or a level. For details, refer to related descriptions of outputting the first voltage by the first voltage module.

In some embodiments, when the signal processing module 51 turns on the first pass transistor 54 based on the first signal, the first summation result is a sum of the fifth logical value and the sixth logical value. When the signal processing module 51 turns on the second pass transistor 55 based on the first signal, the first summation result is a sum of the sixth logical value plus 1 and the fifth logical value. When the signal processing module 51 turns on the third pass transistor 56 based on the first signal, the first summation result is a sum of the sixth logical value minus 1 and the fifth logical value. In this way, the adder circuit 50 may output the first summation result of the first signal and the second signal.

Refer to FIG. 5. In some embodiments, the signal processing module 51 may include a first NTI 511, a second NTI 512, a PTI 513, and an NOR gate 514.

The first signal module is separately connected to a first end of the first NTI 511 and a first end of the PTI 513, a second end of the first NTI 511 is separately connected to the first pass transistor 54 and a first input end of the NOR gate 514, a second end of the PTI 513 is connected to a first end of the second NTI 512, a second end of the second NTI 512 is separately connected to a second input end of the NOR gate 514 and the third pass transistor 56, and an output end of the NOR gate 514 is connected to the second pass transistor 55. In some embodiments, the first end of the NTI may be considered as an input end of the NTI, the second end of the NTI may be considered as an output end of the NTI, the first end of the PTI may be considered as an input end of the PTI, and the second end of the PTI may be considered as an output end of the PTI.

The following describes a process in which the adder circuit 50 outputs a first summation result $SUM_{AB}$ by using an example in which the first signal is a ternary signal A and the second signal is a ternary signal B.

When the ternary signal A passes through the first NTI 511, the first NTI 511 may output an A0 signal. When the ternary signal A passes through the PTI 513 and the second NTI 512, the second NTI 512 may output an A2 signal. When the A0 signal and the A2 signal pass through the NOR gate 514, the NOR gate 514 may output an A1 signal.

The A0 signal is used to turn off or turn on the first pass transistor 54. The A1 signal is used to turn off or turn on the second pass transistor 55. The A2 signal is used to turn off or turn on the third pass transistor 56.

In some embodiments, a pass transistor includes two transistors with opposite polarities. Specifically, the pass transistor includes an NPN transistor and a PNP transistor that are connected back to back. A back-to-back connection between the NPN transistor and the PNP transistor may be understood as follows: A source of the NPN transistor is connected to a drain of the PNP transistor, and a drain of the NPN transistor is connected to a source of the PNP transistor; or a source of the NPN transistor is connected to a source of the PNP transistor, and a drain of the NPN transistor is connected to a drain of the PNP transistor.

For example, the ternary signal A indicates a fifth logical value 2. The A2 signal may be output after the ternary signal A passes through the PTI 513 and the second NTI 512, and the A2 signal indicates a logical value 2. The A2 signal may be used to turn on the third pass transistor. In this way, the adder circuit may output the first summation result of "the sum of the sixth logical value minus 1 and the fifth logical value".

For example, the ternary signal A indicates a fifth logical value 1, and the A1 signal output by the NOR gate 514 may be used to turn on the second pass transistor. In this way, the adder circuit may output the first summation result of "the sum of the sixth logical value plus 1 and the fifth logical value".

For example, the ternary signal A indicates a fifth logical value 0. The A0 signal may be output after the ternary signal A passes through the first NTI 511, and the A0 signal indicates a logical value 2. The A0 signal may be used to turn on the first pass transistor. In this way, the adder circuit may output the first summation result of "the sum of the fifth logical value and the sixth logical value".

An embodiment of this application provides an adder circuit. The adder circuit may perform summation calculation on a ternary signal A and a ternary signal B, and output a first summation result.

In the foregoing adder circuit, summation calculation may be performed on the ternary signal A and the ternary signal B. However, based on a ternary summation calculation principle, carry exists when summation calculation is performed on the ternary signal A and the ternary signal B. To ensure accuracy of summation calculation, an embodiment of this application provides a half-adder circuit based on the adder circuit. A carry generator is added in the half-adder circuit based on the adder circuit, to perform summation calculation on the ternary signal A and the ternary signal B more accurately.

In some embodiments, the half-adder circuit includes the adder circuit 50 in the foregoing embodiments. In some embodiments, the half-adder circuit may be referred to as a half-adder (half-adder).

Refer to FIG. 6. In some embodiments, the half-adder circuit 60 may include the adder circuit 50 and a first carry generator 61. A first signal module is separately connected to the adder circuit 50 and the first carry generator 61, and a second signal module is separately connected to the adder circuit 50 and the first carry generator 61.

A structure of the first carry generator 61 may be the same as a structure of a carry generator in a binary logic circuit. For details, refer to an enlarged schematic of the first carry generator 61 in FIG. 6. In the enlarged schematic of the first carry generator 61, $A_n$ indicates that a first signal is output to the first carry generator 61 after being processed by an NTI, $A_P$ indicates that the first signal is output to the first carry generator 61 after being processed by a PTI, $B_n$ indicates that a second signal is output to the first carry generator 61 after being processed by the NTI, and $B_P$ indicates that the second signal is output to the first carry generator 61 after being processed by the PTI.

The adder circuit 50 is configured to output a first summation result of the first signal and the second signal. In FIG. 6, $SUM_{AB}$ represents the first summation result. In some embodiments, $SUM_{AB}$ may also be referred to as a summation result of the half-adder circuit 60 (sum of half-adder).

The first carry generator is configured to output a first carry result obtained by summing the first signal and the second signal. In FIG. 6, $Carry_{AB}$ represents the first carry result. In some embodiments, $Carry_{AB}$ may also be referred to as a carry result of the half-adder circuit 60 (carry of half-adder).

An embodiment of this application provides a half-adder circuit. When performing summation calculation on a first signal and a second signal, the half-adder circuit can not only output a first summation result of the first signal and the second signal, but also output a first carry result of summation calculation on the first signal and the second signal, so that a summation calculation result of the first signal and the second signal can be accurately output.

Based on the adder circuit 50 and the half-adder circuit 60 provided in the foregoing embodiments, an embodiment of this application provides a full-adder circuit. The full-adder circuit may include the half-adder circuit 60 in the foregoing embodiment. The full-adder circuit is configured to implement summation calculation on three ternary signals. For a ternary full-adder circuit, similar to binary calculation, the ternary full-adder circuit may include three input signals: a ternary signal A, a ternary signal B, and a ternary signal C. An output of the ternary full-adder circuit is a sum signal $SUM_{ABC}$ and a carry signal $Carry_{ABC}$. In some embodiments, the full-adder circuit may be referred to as a full-adder.

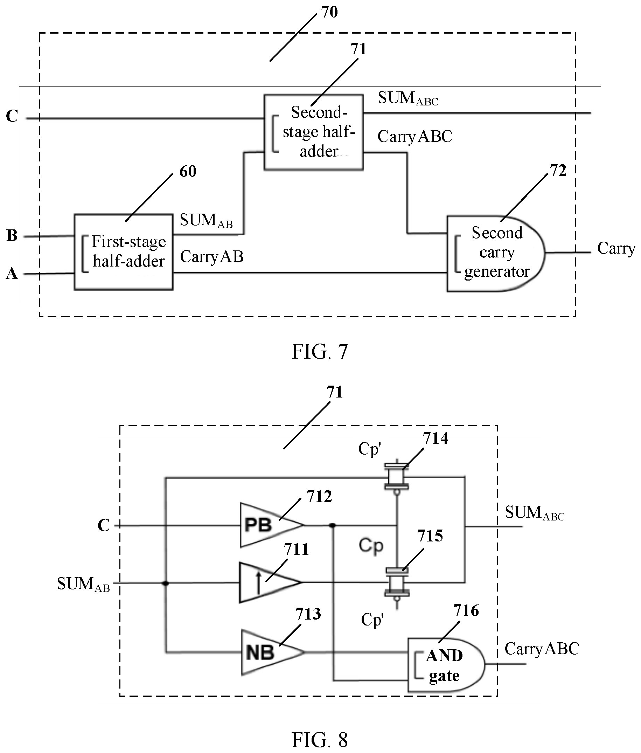

Refer to FIG. 7. In some embodiments, a full-adder circuit 70 may include a first-stage half-adder circuit 60, a second-stage half-adder circuit 71, and a second carry generator 72. The second-stage half-adder circuit 71 is configured to connect to a third signal module.

In some embodiments, the full-adder circuit 70 may include the third signal module. In some embodiments, because the first-stage half-adder circuit 60 may include a first signal module and a second signal module, the full-adder circuit 70 may include the first signal module, the second signal module, and the third signal module.

For a structure of the first-stage half-adder circuit 60, refer to FIG. 6. The first-stage half-adder circuit 60 is configured to: output a first summation result (for example, $SUM_{AB}$) to the second-stage half-adder circuit 71, and output a first carry result ($Carry_{AB}$) to the second carry generator 72.

The third signal module is configured to output a third signal to the second-stage half-adder circuit 71. The third signal is a ternary signal. For example, in FIG. 7, the third signal is a ternary signal C.

In some embodiments, the second-stage half-adder circuit 71 is configured to: perform summation calculation on the first summation result and the third signal, output a second summation result, and output a second carry result to the second carry generator 72. The second summation result is a result of summation calculation on the first summation result and the third signal. In FIG. 7, the second summation result is represented as $SUM_{ABC}$. The second carry result is a carry result of summation calculation on the first summation result and the third signal. In FIG. 7, the second carry result is represented as $Carry_{ABC}$.

In some embodiments, a structure of the second-stage half-adder circuit 71 may be the same as a structure of the first-stage half-adder circuit 60. Refer to FIG. 6.

In some embodiments, in the second-stage half-adder, because carry resulting from a sum of the first signal and the second signal can only be a logical value 0 or a logical value 1, and a logical value 2 does not occur, in the second-stage half-adder, only a +0 operation (for example, using a buffer) or a +1 operation (for example, using an auto-addition logic gate circuit) needs to be performed on a calculation path, and there is no need to use an auto-substraction logic gate circuit.

In some embodiments, the second-stage half-adder circuit 71 may include a third ternary logic gate circuit. In the third ternary logic gate circuit, a second logical value output by the third ternary logic gate circuit is equal to a first logical value plus 1. In other words, the third ternary logic gate circuit is an auto-addition logic gate circuit.

Refer to FIG. 8. The second-stage half-adder circuit 71 may include a third ternary logic gate circuit 711, a positive buffer (positive buffer, PB) 712, a negative buffer (negative buffer, NB) 713, a fourth pass transistor 714, a fifth pass transistor 715, and an AND gate 716.

The third signal module is separately connected to an input end of the PB 712 and the fourth pass transistor 714, and an output end of the PB 712 is separately connected to the fifth pass transistor 715 and a second input end of the AND gate 716. The fourth pass transistor 714 is connected to the fifth pass transistor 715.

The first-stage half-adder circuit 60 is separately connected to the third ternary logic gate circuit 711 and an input end of the NB 713, the third ternary logic gate circuit 711 is connected to the fifth pass transistor 715, and an output end of the NB 713 is connected to a first input end of the AND gate 716.

In this embodiment of this application, the first summation result output by the first-stage half-adder circuit 60 may be processed by the third ternary logic gate circuit 711 and then a signal is output; or the first summation result output by the first-stage half-adder circuit 60 may be processed by the NB 713 and then a signal is output.

The following briefly describes structures and functions of the PB 712 and the NB 713.

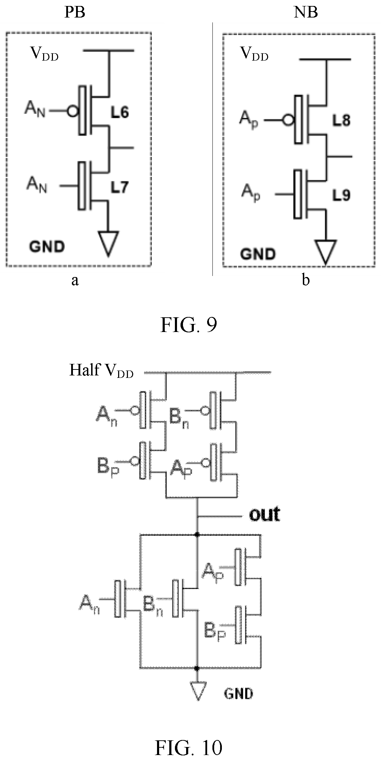

a in FIG. 9 shows the structure of the PB 712. Refer to a in FIG. 9. The PB 712 may include two transistors, and the two transistors are respectively a twelfth transistor L6 and a thirteenth transistor L7. A voltage threshold of the twelfth transistor L6 is less than the first threshold, and a voltage threshold of the thirteenth transistor L7 is less than the first threshold. The twelfth transistor L6 is a P-type transistor, and the thirteenth transistor L7 is an N-type transistor.

In some embodiments, the second-stage half-adder circuit 71 further includes a third NTI. The third signal module is configured to connect to a first end of the third NTI, and a second end of the third NTI is connected to the input end of the PB 712. It may be understood that the third signal module may output a third signal, and the third signal is output to the PB 712 after being processed by the third NTI.

In the PB 712, the second end of the third NTI is separately connected to a gate of the twelfth transistor L6 and a gate of the thirteenth transistor L7, a source of the twelfth transistor L6 is connected to the second voltage module, a drain of the twelfth transistor L6 is connected to a source of the thirteenth transistor L7, and a drain of the thirteenth transistor L7 is grounded. In addition, a source of the thirteenth transistor L7 may be separately connected to the fifth pass transistor 715 and the second input end of the AND gate 716.

When an input of the PB 712 is a logical value 0, the PB 712 may output a logical value 0. When an input of the PB 712 is a logical value 1, the PB 712 may output a logical value 2. When an input of the PB 712 is a logical value 2, the PB 712 may output a logical value 2.

b in FIG. 9 shows the structure of the NB 713. Refer to b in FIG. 9. The NB 713 may include two transistors, and the two transistors are respectively a fourteenth transistor L8 and a fifteenth transistor L9. A voltage threshold of the fourteenth transistor L8 is less than the first threshold, and a voltage threshold of the fifteenth transistor L9 is less than the first threshold. The fourteenth transistor L8 is a P-type transistor, and the fifteenth transistor L9 is an N-type transistor.

In some embodiments, the second-stage half-adder circuit 71 further includes a second PTI. The third signal module is configured to connect to a first end of the second PTI, and a second end of the second PTI is connected to the input end of the NB 713. It may be understood that the third signal module may output a third signal, and the third signal is output to the NB 713 after being processed by the PTI.

In the NB 713, the second end of the second PTI is separately connected to a gate of the fourteenth transistor L8 and a gate of the fifteenth transistor L9, a source of the fourteenth transistor L8 is connected to the second voltage module, a drain of the fourteenth transistor L8 is connected to a source of the fifteenth transistor L9, and a drain of the fifteenth transistor L9 is grounded. In addition, a source of the fifteenth transistor L9 may be connected to the first input end of the AND gate 716.

When an input of the NB 713 is a logical value 0, the NB 713 may output a logical value 0. When an input of the NB 713 is a logical value 1, the NB 713 may output a logical value 0. When an input of the NB 713 is a logical value 2, the NB 713 may output a logical value 2.

The third signal output by the third signal module is used to turn on the fourth pass transistor 714 or the fifth pass transistor 715, to enable the full-adder circuit 70 to output the second summation result.

For example, the first summation result is $SUM_{AB}$. When the third signal indicates a logical value 1, a logical value 2 is output after the third signal passes through the PB 712, the fifth pass transistor 715 may be turned on, and the fifth pass transistor 715 may output $SUM_{AB}+1$, and the second summation result is $SUM_{ABC}=SUM_{AB}+1+C$, where C represents a logical value represented by the ternary signal C.

For example, the first summation result is $SUM_{AB}$. When the third signal indicates a logical value 0, a logical value 0 is output after the third signal passes through the PB 712, the fourth pass transistor 714 may be turned on, the fifth pass transistor 715 is turned off, and the second summation result is $SUM_{ABC}=SUM_{AB}+C$, where C represents a logical value represented by the ternary signal C.

In FIG. 7, the second carry generator 72 is configured to output a third carry result Carry based on the first carry result $Carry_{AB}$ and the second carry result $Carry_{ABC}$.

In some embodiments, a structure of the second carry generator 72 may be the same as that of the first carry generator 71.

In some embodiments, for the structure of the second carry generator 72, refer to FIG. 10. In FIG. 10, $A_n$ represents that the first carry result $Carry_{AB}$ is output to the second carry generator 72 after being processed by the NTI, $A_P$ represents that the first carry result $Carry_{AB}$ is output to the second carry generator 72 after being processed by the PTI, $B_n$ represents that the second carry result $Carry_{ABC}$ is output to the second carry generator 72 after being processed by the NTI, and $B_P$ represents that the second carry result $Carry_{ABC}$ is output to the second carry generator 72 after being processed by the PTI. Out represents an output (Carry) of the second carry generator, and half $V_{DD}$ represents $V_{DD}/2$.

As shown in FIG. 10, the second carry generator 72 includes a plurality of low voltage threshold transistors of different polarities. A voltage threshold of a P-type transistor may be, for example, -0.323 V, and a voltage threshold of an N-type transistor may be, for example, 0.323 V.

In embodiments of this application, an adder circuit may be designed based on an auto-addition logic gate circuit and an auto-substraction logic gate circuit, a half-adder circuit is designed based on the adder circuit, and a full-adder circuit that can perform summation on three ternary signals is designed based on a first-stage half-adder circuit. In this way, the full-adder circuit has a small quantity of transistors, low power consumption, and high computing efficiency.

In some embodiments, an embodiment of this application further provides a multiplication circuit. The multiplication circuit includes the adder circuit 50 in the foregoing embodiments and the half-adder circuit 60 in the foregoing embodiments. The adder circuit 50 and the half-adder circuit 60 provided in embodiments of this application are applied to a larger-scale ternary multiplication circuit. The ternary multiplication circuit has a small quantity of transistors, low power consumption, and high computing efficiency.

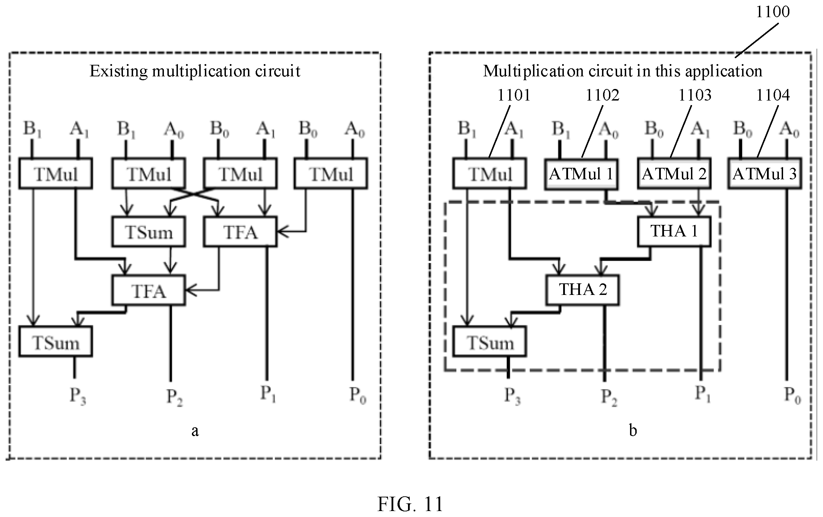

A 2trit*2trit multiplication circuit is used as an example. a in FIG. 11 shows an existing ternary multiplication circuit. Refer to a in FIG. 11, a current ternary multiplication circuit needs to use four multipliers TMul, two adder circuits, and two full-adder circuits. If an adder circuit and a full-adder circuit in the conventional technology are used as the adder circuit and the full-adder circuit, the multiplication circuit has a large quantity of transistors and low computing efficiency.

In some embodiments, the adder circuit 50 and the full-adder circuit 70 provided in embodiments of this application may be used in a in FIG. 11, so that a quantity of transistors in the multiplication circuit can be reduced, and computing efficiency of the multiplication circuit can be improved. It should be understood that, in a in FIG. 11, Tsum (ternary Sum) represents an adder circuit, TFA (ternary full adder) represents a full-adder circuit, and TMul represents a 1trit multiplier.

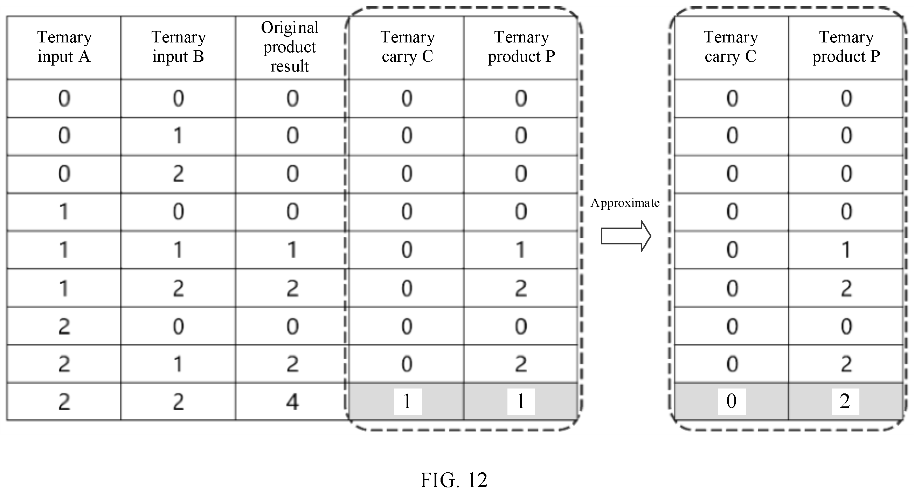

In some embodiments, to further reduce a quantity of transistors in the multiplication circuit, in this embodiment of this application, an idea of approximate multiplication calculation may be used. Approximate multiplication calculation may achieve higher calculation performance and lower power consumption by tolerating a small calculation error. A basic solution of 1trit ternary approximate calculation multiplication is shown in FIG. 12. Refer to FIG. 12. It can be learned that, carry C of 1trit ternary multiplication calculation is 1 only when both an input A and an input B are 2, and carry is 0 in all other cases. If the approximation solution is used, approximation calculation is performed on an input A=B=2, and carry can be ignored in all cases in the circuit.

In some embodiments, the multiplication circuit may include the adder circuit 50, the half-adder circuit 60, a multiplier, and an approximate multiplier. In this embodiment of this application, based on the idea of approximate multiplication calculation, some multipliers in the current ternary multiplication circuit may be replaced with approximate multipliers. In this way, a quantity of transistors in the multiplication circuit can be reduced.

The multiplier is configured to output a first multiplication result. The approximate multiplier is configured to output a second multiplication result, where the second multiplication result may be understood as a multiplication result obtained through approximate multiplication calculation. The adder circuit and the half-adder circuit are configured to output a third multiplication result based on the first multiplication result and the second multiplication result.

To facilitate comparison with a current ternary multiplication circuit, a 2trit*2trit multiplication circuit is used as an example. b in FIG. 11 shows a multiplication circuit provided in an embodiment of this application.

Refer to b in FIG. 11. A multiplication circuit 1100 may include a multiplier 1101, a first approximate multiplier 1102, a second approximate multiplier 1103, a third approximate multiplier 1104, an adder circuit 60, a first half-adder circuit 50, and a second half-adder circuit 50.

It should be understood that structures of the first half-adder circuit 50 and the second half-adder circuit 50 are the same. For details, refer to the descriptions of the half-adder circuit 50 in the foregoing embodiments. In b in FIG. 11, an example in which inputs include "$A_0$ and $B_0$", "$A_1$ and $B_0$", "$A_0$ and $B_1$", and "$A_1$ and $B_1$" is used. $A_0$, $B_0$, $A_1$, and $B_1$ are all ternary signals. In some embodiments, "$A_0$ and $B_0$" may be referred to as a first group of ternary signals, "$A_1$ and $B_0$" may be referred to as a second group of ternary signals, "$A_0$ and $B_1$" may be referred to as a third group of ternary signals, and "$A_1$ and $B_1$" may be referred to as a fourth group of ternary signals.

In addition, in b in FIG. 11, Tsum (ternary Sum) represents the adder circuit 60, THA 1 (ternary half-adder) represents the first half-adder circuit 50, THA 2 represents the second half-adder circuit 50, TMul represents a 1trit multiplier, ATMul 1 represents the first approximate multiplier, ATMul 2 represents the second approximate multiplier, and ATMul 3 represents the third approximate multiplier.

The first approximate multiplier ATMul 1 may perform multiplication calculation on the first group of ternary signals, and output a first multiplication sub-result, for example, $P_0$.

The second approximate multiplier ATMul2 may perform multiplication calculation on the second group of ternary signals, and output a second multiplication sub-result to the first half-adder circuit THA 1. The third approximate multiplier ATMul 3 may perform multiplication calculation on the third group of ternary signals, and output a third multiplication sub-result to the first half-adder circuit THA 1. The first half-adder circuit THA 1 may output a fourth multiplication sub-result $P_1$ based on the second multiplication sub-result and the third multiplication sub-result, and output a fifth multiplication sub-result to the second half-adder circuit THA 2.

The multiplier TMul may perform multiplication calculation on the fourth group of ternary signals, and output a first multiplication result to the second half-adder circuit THA 2. The second half-adder circuit THA 2 is configured to: output a sixth multiplication sub-result $P_2$ based on the fifth multiplication sub-result and the first multiplication result, and output a seventh multiplication sub-result to the adder circuit Tsum.

The adder circuit Tsum is configured to output an eighth multiplication sub-result $P_2$ based on the first multiplication result and the seventh multiplication sub-result.

For the third multiplication result output by the adder circuit and the half-adder circuit, the third multiplication result may include the first multiplication sub-result, the fourth multiplication sub-result, the sixth multiplication sub-result, and the eighth multiplication sub-result.

The multiplication circuit provided in this embodiment of this application may be applied to any scenario in which ternary multiplication calculation is required.

In some embodiments, because the multiplication circuit in this embodiment of this application is based on an idea of approximate multiplication, the multiplication circuit provided in this embodiment of this application may be used in a scenario in which precise calculation is not required (for example, an artificial intelligence neural network algorithm). The multiplication circuit based on approximate multiplication calculation provided in this embodiment of this application can effectively reduce circuit complexity, and implement a new high-efficiency and low-power-consumption algorithm acceleration application.

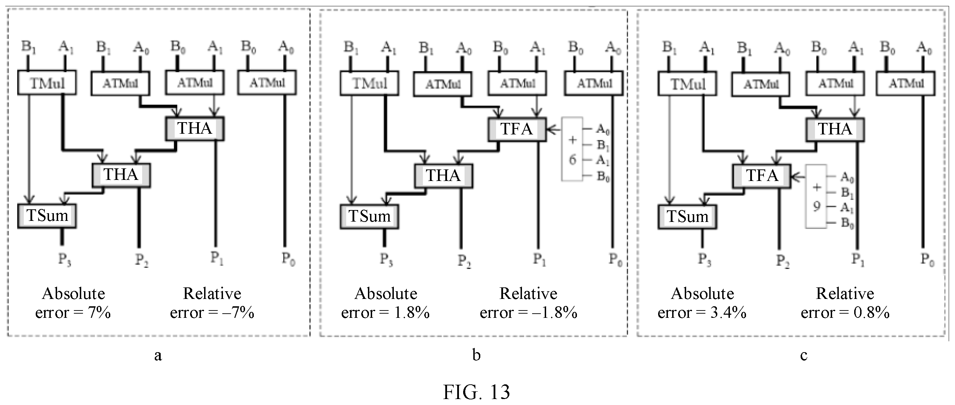

In some embodiments, to reduce a calculation error of the multiplication circuit, an additional compensation unit may be added to the multiplication circuit. As shown in b in FIG. 13, the multiplication circuit may include a first compensation unit, and the first compensation unit may implement a +6 operation. As shown in c in FIG. 13, the multiplication circuit may include a second compensation unit, and the second compensation unit may implement a +9 operation. It should be understood that a in FIG. 13 shows the multiplication circuit shown in b in FIG. 11, and ATMul 1, ATMul 2, ATMul 3, TFA 1, and TFA 2 are not marked in FIG. 13. For details, refer to b in FIG. 11.

In addition, FIG. 13 shows a relative error and an absolute error of each multiplication circuit during multiplication calculation.

In this embodiment of this application, the additional compensation unit is added to the multiplication circuit to implement a +6 or +9 operation, so that a calculation error of the multiplication circuit can be effectively reduced, and only a new addition module is added at a hardware cost of the multiplication circuit. Because the "+9" operation is equivalent to "+1" to a P2 bit in a ternary numeral system, and the "+6" operation is equivalent to "+2" to a P1 bit in the ternary numeral system, the first compensation unit and the second compensation unit may be implemented by using the adder circuit or the full-adder circuit.

In some embodiments, a plurality of 2trit*2trit ternary multiplication circuits may be cascaded to further expand the multiplication circuit, to implement a larger-scale multiplication circuit. For example, in this embodiment of this application, a 6trit*6trit ternary multiplication circuit is used as an example.

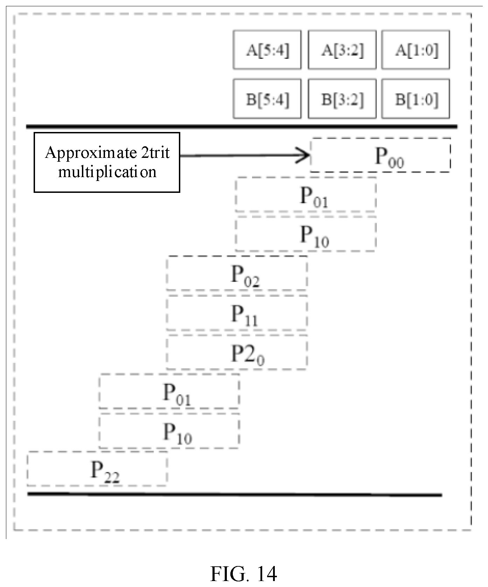

Refer to FIG. 14. For 6trit ternary input signals A and B, A and B are grouped by 2 bits, to obtain A[5:4], A[3:2], A[1:0], B[5:4], B[3:2], and B[1:0] respectively. A multiplication operation is performed by using 2trit as a basic unit, and a plurality of groups of partial products such as P00=A[1:0]*B[1:0], P01=A[3:2]*B[1:0], and P10=A[1:0]*B[3:2] may be obtained in sequence. Then, weighted summation is performed on these partial products (a precise calculation mode is used in a summation process), to obtain a 6trit*6trit ternary multiplication approximation calculation result.

It should be understood that, in this embodiment of this application, the 6trit*6trit ternary multiplication circuit is used as an example. It may be figured out that the multiplication circuit provided in this embodiment of this application may be applied to a circuit design of a larger scale and a circuit design of any scale, and both belong to the protection scope of embodiments of this application.

For example, if in a decimal numeral system, A is 379, and B is 537, A×B=203523. In a ternary numeral system, A may be represented as 112001, and B may be represented as 201220.

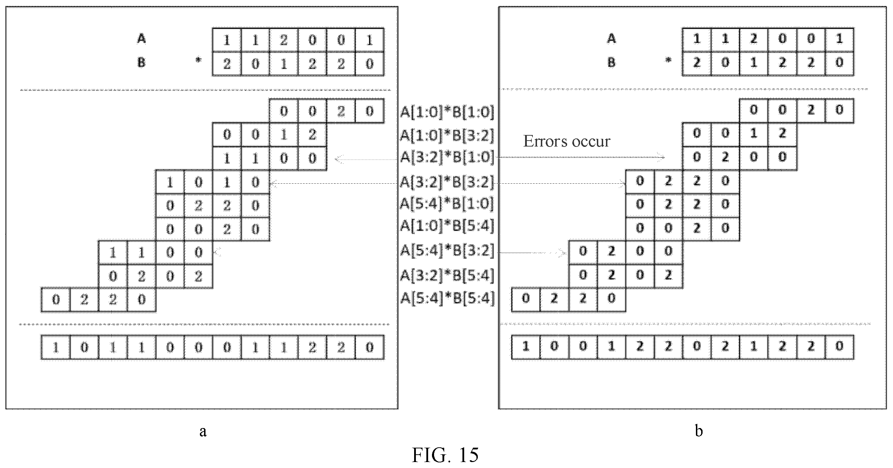

a in FIG. 15 shows a process of calculating A×B by using a current multiplication circuit (for example, a in FIG. 11), and b in FIG. 15 shows a process of calculating A×B by using a multiplication circuit (for example, b in FIG. 11) provided in an embodiment of this application. A multiplication result obtained by performing multiplication calculation on A and B by the multiplication circuit provided in this embodiment of this application has a small error.

In some embodiments, an embodiment of this application provides a chip, and the chip may include any one of the following: the first ternary logic gate circuit, the second ternary logic gate circuit, the adder circuit 50, the half-adder circuit 60, the full-adder circuit 70, and the multiplication circuit 1100. In some embodiments, the chip may be referred to as a first chip.

In some embodiments, an embodiment of this application provides a chip, and the chip may include at least one of the following: the adder circuit 50, the half-adder circuit 60, the full-adder circuit 70, and the multiplication circuit 1100. In some embodiments, the chip may be referred to as a second chip.

In some embodiments, an embodiment of this application provides an electronic device, and the electronic device may include the first chip or the second chip.

The electronic device in this embodiment of this application may be a mobile phone, a tablet computer (portable Android device, PAD tablet), a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in a smart home (smart home), or the like. A form of the electronic device is not specifically limited in this embodiment of this application.

It should be noted that data (including but not limited to data used for analysis, stored data, displayed data, and the like) in this application is information and data that are authorized by a user or fully authorized by all parties. In addition, collection, use, and processing of related data need to comply with related laws, regulations, and standards of related countries and regions, and corresponding operation entries are provided for the user to choose to authorize or reject.

All or some of the foregoing embodiments may be implemented by using software, hardware, firmware, or any combination thereof. When the foregoing embodiments are implemented by using software, all or some of the embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive Solid-State Drive (SSD)), or the like.

The term "a plurality of" in this specification means two or more. The term "and/or" in this specification describes only an association relationship for describing associated objects and represents that three relationships may exist. For example, A and/or B may represent the following three cases: Only A exists, both A and B exist, and only B exists. In addition, a character "/" in this specification usually indicates an "or" relationship between associated objects, and a character "/" in a formula usually indicates a "division" relationship between associated objects. In addition, it should be understood that in descriptions of this application, terms such as "first" and "second" are merely used for distinguishing and description, but should not be understood as indicating or implying relative importance, or should not be understood as indicating or implying a sequence.

It may be understood that various numbers in embodiments of this application are merely used for distinguishing for ease of description, and are not used to limit the scope of embodiments of this application.

It should be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

**Claims**

1. A ternary logic gate circuit, comprising a first voltage module and a logic gate module, wherein

the first voltage module is configured to output a first voltage, wherein the first voltage indicates a first logical value, and the first logical value is any logical value in ternary logical values; and
the logic gate module is configured to: receive the first voltage, and output a second voltage, wherein the second voltage indicates a second logical value, and the second logical value is equal to the first logical value plus 1, or the second logical value is equal to the first logical value minus 1.

2. The ternary logic gate circuit according to claim 1, wherein the logic gate module comprises a preprocessing unit, a first processing unit, and a second processing unit;

the preprocessing unit is configured to: receive the first voltage, and output a third voltage to the first processing unit, wherein the third voltage indicates a third logical value, and the third logical value is 0 or 2;
the first processing unit is configured to: receive the first voltage and the third voltage, and output a fourth voltage to the second processing unit, wherein the fourth voltage indicates a fourth logical value, and the fourth logical value comprises 0 or 2; and
the second processing unit is configured to: receive the fourth voltage, and output the second voltage.

3. The ternary logic gate circuit according to claim 2, wherein the first processing unit comprises a first group of transistors and a second group of transistors, the second processing unit comprises a third group of transistors, a threshold voltage of a transistor in the first group of transistors is a first threshold voltage, a threshold voltage of a transistor in the second group of transistors is a second threshold voltage, and a threshold voltage of a transistor in the third group of transistors is a third threshold voltage;

the first threshold voltage is less than or equal to a first threshold, the third threshold voltage is greater than the first threshold and less than or equal to a second threshold, the second threshold voltage is greater than the second threshold, and the first threshold is less than the second threshold; and
the first voltage module is separately connected to the preprocessing module, a part of transistors in the first group of transistors, and the transistor in the second group of transistors, the preprocessing module is connected to remaining transistors in the first group of transistors, and the transistor in the third group of transistors is connected to the transistor in the first group of transistors and the transistor in the second group of transistors.

4. The ternary logic gate circuit according to claim 3, wherein the first group of transistors comprises a first transistor, a second transistor, and a third transistor, the second group of transistors comprises a fourth transistor and a fifth transistor, and the third group of transistors comprises a sixth transistor and a seventh transistor.

5. The ternary logic gate circuit according to claim 4, wherein the preprocessing module is a negative ternary inverter NTI, the first transistor, the second transistor, the fourth transistor, and the sixth transistor are P-type transistors, and the third transistor, the fifth transistor, and the seventh transistor are N-type transistors;

the first voltage module is separately connected to a gate of the first transistor, a gate of the fourth transistor, and a gate of the fifth transistor, and the NTI is separately connected to a gate of the second transistor and a gate of the third transistor;
a source of the first transistor is connected to a second voltage module, a drain of the first transistor is connected to a source of the second transistor, a drain of the second transistor is separately connected to a source of the third transistor and a source of the sixth transistor, a drain of the third transistor is grounded, a gate of the sixth transistor is grounded, and a drain of the sixth transistor is connected to a drain of the seventh transistor;
a source of the fourth transistor is connected to the second voltage module, a drain of the fourth transistor is separately connected to a source of the fifth transistor and a source of the seventh transistor, a drain of the fifth transistor is grounded, and a gate of the seventh transistor is connected to the second voltage module;
the second voltage module is configured to output a fifth voltage, wherein a sum of the first threshold voltage and the second threshold voltage is less than the fifth voltage; and
the second logical value is equal to the first logical value plus 1.

6. The ternary logic gate circuit according to claim 4, wherein the preprocessing module is a positive ternary inverter PTI, the first transistor, the fourth transistor, and the sixth transistor are P-type transistors, and the second transistor, the third transistor, the fifth transistor, and the seventh transistor are N-type transistors;

the first voltage module is separately connected to a gate of the third transistor, a gate of the fourth transistor, and a gate of the fifth transistor, and the PTI is separately connected to a gate of the first transistor and a gate of the second transistor;
a source of the first transistor is connected to a second voltage module, a drain of the first transistor is separately connected to a source of the second transistor and a source of the seventh transistor, a drain of the second transistor is connected to a source of the third transistor, a drain of the third transistor is grounded, a gate of the seventh transistor is connected to the second voltage module, and a drain of the seventh transistor is connected to a drain of the sixth transistor;
a source of the fourth transistor is connected to the second voltage module, a drain of the fourth transistor is separately connected to a source of the fifth transistor and a source of the sixth transistor, a drain of the fifth transistor is grounded, and a gate of the sixth transistor is grounded;
the second voltage module is configured to output a fifth voltage, wherein a sum of the first threshold voltage and the second threshold voltage is less than the fifth voltage; and
the second logical value is equal to the first logical value minus 1.

7. An adder circuit, comprising the first ternary logic gate circuit according to any one of claims 1 to 5 and the second ternary logic gate circuit according to any one of claims 1 to 4 or 6, wherein in the first ternary logic gate circuit, the second logical value is equal to the first logical value plus 1, and in the second ternary logic gate circuit, the second logical value is equal to the first logical value minus 1.

8. The adder circuit according to claim 7, further comprising a signal processing module, a first pass transistor, a second pass transistor, and a third pass transistor, wherein

the signal processing module is configured to connect to a first signal module, and the signal processing module is separately connected to the first pass transistor, the second pass transistor, and the third pass transistor;
a second signal module is configured to separately connect to the first pass transistor, the first ternary logic gate circuit, and the second ternary logic gate circuit, the first ternary logic gate circuit is connected to the second pass transistor, and the second ternary logic gate circuit is connected to the third pass transistor;
the second signal module is configured to output a second signal;
the first signal module is configured to output a first signal; and
the signal processing module is configured to turn on any pass transistor based on the first signal, to enable the adder circuit to output a first summation result of the first signal and the second signal.

9. The adder circuit according to claim 8, wherein the first signal indicates a fifth logical value, and the second signal indicates a sixth logical value;

when the first pass transistor is turned on, the first summation result is a sum of the fifth logical value and the sixth logical value;
when the second pass transistor is turned on, the first summation result is a sum of the sixth logical value plus 1 and the fifth logical value; and
when the third pass transistor is turned on, the first summation result is a sum of the sixth logical value minus 1 and the fifth logical value.

10. The adder circuit according to claim 8 or 9, wherein the signal processing module comprises a first negative ternary inverter NTI, a second NTI, a positive ternary inverter PTI, and an NOR gate; and
the first signal module is separately connected to a first end of the first NTI and a first end of the PTI, a second end of the first NTI is separately connected to the first pass transistor and a first input end of the NOR gate, a second end of the PTI is connected to a first end of the second NTI, a second end of the second NTI is separately connected to a second input end of the NOR gate and the third pass transistor, and an output end of the NOR gate is connected to the second pass transistor.

11. A half-adder circuit, comprising: the adder circuit according to any one of claims 7 to 10.

12. The half-adder circuit according to claim 11, further comprising a first carry generator; and

a first signal module, configured to separately connect to the adder circuit and the first carry generator, and a second signal module, configured to separately connect to the adder circuit and the first carry generator, wherein the first carry generator is configured to output a first carry result.

13. A full-adder circuit, comprising the half-adder circuit according to claim 11 or 12, wherein the half-adder circuit is used as a first-stage half-adder circuit.

14. The full-adder circuit according to claim 13, further comprising a second-stage half-adder circuit and a second carry generator, wherein the second-stage half-adder circuit is configured to connect to a third signal module;

the first-stage half-adder circuit is configured to: output a first summation result to the second-stage half-adder circuit, and output a first carry result to the second carry generator;
the third signal module is configured to output a third signal to the second-stage half-adder circuit;
the second-stage half-adder circuit is configured to: output, based on the third signal and the first summation result, a second summation result, and output a second carry result to the second carry generator; and
the second carry generator is configured to output a third carry result based on the first carry result and the second carry result.

15. The full-adder circuit according to claim 14, wherein the second-stage half-adder circuit comprises the third ternary logic gate circuit according to any one of claims 1 to 5, and in the third ternary logic gate circuit, the second logical value is equal to the first logical value plus 1.

16. The full-adder circuit according to claim 15, wherein the second-stage half-adder circuit comprises a positive buffer PB, a negative buffer NB, a fourth pass transistor, a fifth pass transistor, an AND gate, and the third ternary logic gate circuit;

the third signal module is separately connected to an input end of the PB and the fourth pass transistor, an output end of the PB is separately connected to the fifth pass transistor and a second input end of the AND gate, and the fourth pass transistor is connected to the fifth pass transistor;
the first-stage half-adder circuit is separately connected to the third ternary logic gate circuit and an input end of the NB, the third ternary logic gate circuit is connected to the fifth pass transistor, and an output end of the NB is connected to a first input end of the AND gate; and
the third signal is used to turn on the fourth pass transistor or the fifth pass transistor, to enable the full-adder circuit to output the second summation result.

17. A multiplication circuit, comprising the adder circuit according to any one of claims 7 to 10 and the half-adder circuit according to claim 11 or 12.

18. The multiplication circuit according to claim 17, further comprising a multiplier and an approximate multiplier, wherein

the multiplier is configured to output a first multiplication result;
the approximate multiplier is configured to output a second multiplication result; and
the adder circuit and the half-adder circuit are configured to output a third multiplication result based on the first multiplication result and the second multiplication result.

19. The multiplication circuit according to claim 18, wherein the approximate multiplier comprises a first approximate multiplier, a second approximate multiplier, and a third approximate multiplier, and the half-adder circuit comprises a first half-adder circuit and a second half-adder circuit;

the first approximate multiplier is configured to output a first multiplication sub-result;
the second approximate multiplier is configured to output a second multiplication sub-result to the first half-adder circuit;
the third approximate multiplier is configured to output a third multiplication sub-result to the first half-adder circuit;
the first half-adder circuit is configured to: output a fourth multiplication sub-result based on the second multiplication sub-result and the third multiplication sub-result, and output a fifth multiplication sub-result to the second half-adder circuit;
the multiplier is further configured to output the first multiplication result to the second half-adder circuit;
the second half-adder circuit is configured to: output a sixth multiplication sub-result based on the fifth multiplication sub-result and the first multiplication result, and output a seventh multiplication sub-result to the adder circuit;

the adder circuit is configured to output an eighth multiplication sub-result based on the first multiplication result and the seventh multiplication sub-result; and

the third multiplication result comprises the first multiplication sub-result, the fourth multiplication sub-result, the sixth multiplication sub-result, and the eighth multiplication sub-result.

20. A chip, comprising the circuit according to any one of claims 1 to 19.

21. A chip, comprising at least one of the following:

the adder circuit according to any one of claims 7 to 10, the half-adder circuit according to claim 11 or 12, the full-adder circuit according to any one of claims 13 to 16, and the multiplication circuit according to any one of claims 17 to 19.

22. An electronic device, comprising the chip according to claim 20 or 21.

FIG. 1A

FIG. 1B

EP 4 769 950 A1

**Ternary logic gate circuit 20**

**21**

First voltage module

First logical value
(ternary)

**22**

Logic gate module

Add 1 to the first logical value
or
subtract 1 from the first logical value

FIG. 2A

EP 4 769 950 A1

**Ternary logic gate circuit 20**

*22*

*221*

Preprocessing unit

*21*

First
logical
value
(ternary)

First voltage module

Third
logical
value

*222*

Fourth
logical
value

*223*

First processing unit

Second processing unit

Add 1 to the first
logical value
or
subtract 1 from the
first logical value

FIG. 2B

FIG. 3

FIG. 4

50

51

511

NTI

514

A0

A

512    513

+        −

PTI    NTI

A1

A2

54

52

55

A0'

B

SUM_AB

53

56

A1'

A2'

FIG. 5

60

50

A

Adder
circuit

SUM_AB

V_DD = 0.5V

61

$A_n$    $B_n$

B

First carry
generator

Carry AB

$B_P$    $A_P$

out

$A_n$    $B_n$    $A_P$

$B_P$

GND

FIG. 6

**70**

**71**

C

Second-stage half-adder

SUM<sub>ABC</sub>

Carry ABC

**60**

**72**

B

First-stage half-adder

SUM<sub>AB</sub>

Carry AB

Second carry generator

Carry

A

FIG. 7

**71**

Cp'

**714**

C

**PB**

**712**

Cp

SUM<sub>ABC</sub>

SUM<sub>AB</sub>

**711**

**715**

**713**

Cp'

**716**

**NB**

**AND gate**

Carry ABC

FIG. 8

PB NB

a b

FIG. 9

FIG. 10

FIG. 11

EP 4 769 950 A1

| Ternary input A | Ternary input B | Original product result | Ternary carry C | Ternary product P |
|:---:|:---:|:---:|:---:|:---:|
| 0 | 0 | 0 | 0 | 0 |
| 0 | 1 | 0 | 0 | 0 |
| 0 | 2 | 0 | 0 | 0 |
| 1 | 0 | 0 | 0 | 0 |
| 1 | 1 | 1 | 0 | 1 |
| 1 | 2 | 2 | 0 | 2 |
| 2 | 0 | 0 | 0 | 0 |
| 2 | 1 | 2 | 0 | 2 |
| 2 | 2 | 4 | 1 | 1 |

Approximate ⟹

| Ternary carry C | Ternary product P |
|:---:|:---:|
| 0 | 0 |
| 0 | 0 |
| 0 | 0 |
| 0 | 0 |
| 0 | 1 |
| 0 | 2 |
| 0 | 0 |
| 0 | 2 |
| 0 | 2 |

FIG. 12

FIG. 13

FIG. 14

FIG. 15

## INTERNATIONAL SEARCH REPORT

| | International application No. |
|---|---|
| | **PCT/CN2024/119205** |

**A. CLASSIFICATION OF SUBJECT MATTER**

H03K 19/20(2006.01)i

According to International Patent Classification (IPC) or to both national classification and IPC

**B. FIELDS SEARCHED**

Minimum documentation searched (classification system followed by classification symbols)

IPC: H03K

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, IEEE, ISI, CNKI: 三进制, 逻辑, 输入, 输出, 加, 减, 电压, 任意, 任一, triple base, logic, input, output, addition, subtraction, voltage, arbitrary, any one

**C. DOCUMENTS CONSIDERED TO BE RELEVANT**

| Category* | Citation of document, with indication, where appropriate, of the relevant passages | Relevant to claim No. |
|---|---|---|
| A | WO 2016199157 A1 (INGOLE, Vijay Tulshiram et al.) 15 December 2016 (2016-12-15) abstract, and claims 1-10 | 1-22 |
| A | CN 111555751 A (HANGZHOU DIANZI UNIVERSITY) 18 August 2020 (2020-08-18) entire document | 1-22 |
| A | CN 115940933 A (TSINGHUA UNIVERSITY) 07 April 2023 (2023-04-07) entire document | 1-22 |
| A | CN 204631850 U (YIBIN UNIVERSITY) 09 September 2015 (2015-09-09) entire document | 1-22 |
| A | US 2014292373 A1 (NINGBO UNIVERSITY) 02 October 2014 (2014-10-02) entire document | 1-22 |

☐ Further documents are listed in the continuation of Box C.    ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **04 November 2024** | **20 November 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/119205**

| Patent document cited in search report | | | Publication date (day/month/year) | Patent family member(s) | | | Publication date (day/month/year) |
|---|---|---|---|---|---|---|---|
| WO | 2016199157 | A1 | 15 December 2016 | IN | 201502258 | I3 | 16 December 2016 |
| CN | 111555751 | A | 18 August 2020 | | None | | |
| CN | 115940933 | A | 07 April 2023 | | None | | |
| CN | 204631850 | U | 09 September 2015 | | None | | |
| US | 2014292373 | A1 | 02 October 2014 | CN | 103219990 | A | 24 July 2013 |

Form PCT/ISA/210 (patent family annex) (July 2022)

**REFERENCES CITED IN THE DESCRIPTION**

**Patent documents cited in the description**

- CN 202311209872